# EUROPÄISCHE PATENTSCHRIFT

(11) **EP 3 447 575 B1**
(45) Veröffentlichungstag und Bekanntmachung des Hinweises auf die Patenterteilung: **03.05.2023**
(21) Anmeldenummer: 18189749.7
(22) Anmeldetag: 20.08.2018
(51) Int. Cl.: G03B 17/12, G03B 17/56

(54) **HALTESTANGE FÜR ZUBEHÖRKOMPONENTE EINER FILMKAMERA**
SUPPORT POLE FOR ACCESSORY COMPONENTS OF A MOTION PICTURE CAMERA
TIGE DE MAINTIEN POUR COMPOSANTS ACCESSOIRES D'UNE CAMÉRA

(30) Priorität: 25.08.2017 DE 102017119532
(43) Veröffentlichungstag der Anmeldung: 27.02.2019
(73) Patentinhaber: Arnold & Richter Cine Technik GmbH & Co. Betriebs KG, 80807 München (DE)
(72) Erfinder: HAUBMANN, Michael, 1230 Wien (AT); TSCHIDA, Christian, 1050 Wien (AT)
(74) Vertreter: Manitz Finsterwald Patent- und Rechtsanwaltspartnerschaft mbB

(56) Entgegenhaltungen:
- EP-A2- 2 722 584
- CN-A- 102 346 360
- US-A- 4 699 484

## Beschreibung

Die vorliegende Erfindung betrifft ein Stützsystem mit einer Haltestange zum Halten einer Zubehörkomponente relativ zu einer Filmkamera in einer variablen Position entlang einer Längsachse der Haltestange. Die Zubehörkomponente kann beispielsweise mittels einer Klemmeinrichtung fest an der Haltestange befestigt werden. Die Position der Zubehörkomponente entlang der Längsachse der Haltestange kann hierbei so festgelegt werden, dass die Zubehörkomponente auf eine gewünschte Weise wirken und insbesondere mit der Filmkamera zusammenwirken kann. Die Haltestange kann z.B. paarweise in ein Stützsystem der Filmkamera integriert werden, wobei mehrere Zubehörkomponenten an der Haltestange befestigt werden können. Ein Stützsystem mit zwei Haltestangen und einer Befestigungseinrichtung (Brücke) zum Befestigen der zwei Haltestangen an einer Filmkamera ist aus US 7575324 B2 bekannt.

Die Zubehörkomponente kann insbesondere ein Stellmotor für einen Objektivring (z.B. Fokusring oder Blendenring) oder für eine Filtereinheit (z.B. verschiedene ND-Filter, Neutraldichte-Filter) sein. Ferner kann die Zubehörkomponente ein Funkmodul für eine drahtlose Datenübertragung (z.B. von Einstelldaten und/oder Bilddaten), eine Ringlichtquelle oder ein Monitor zum Anzeigen von Daten sein. Zubehörkomponenten der Filmkamera dienen somit zum Betrieb der Filmkamera, wobei die Kamera relativ zu einer Basisfunktionalität erweitert bzw. aufgerüstet werden kann. Die Filmkamera kann eine herkömmliche Filmkamera (Aufzeichnung auf fotochemischem Film) oder eine elektronische Filmkamera (Aufzeichnung von digitalen Bilddaten in einem elektronischen Speichermedium) sein.

Im Falle einer elektrisch betriebenen Zubehörkomponente kann die elektrische Versorgung und/oder die Anbindung an die Filmkamera über flexible elektrisch isolierte Leiter, d.h. über (Versorgungs-)Kabel erfolgen. Der Einsatz von Kabeln, die insbesondere bei mehreren Zubehörkomponenten in höherer Anzahl vorzusehen sind, ist jedoch mit Problemen verbunden. So benötigen Kabel Platz in der Umgebung der Zubehörkomponente und versperren die Sicht. Ferner bergen Kabei die Gefahr, dass der Benutzer oder ein Gegenstand hieran hängenbleibt. Ferner kann sich das Kabel ungewollt lösen und zu einem Ausfall der betreffenden Zubehörkomponente führen, der unerwünschte Ausfallzeiten der Filmkamera nach sich ziehen kann. Ein weiteres Problem besteht darin, dass die variable Positionierung der Zubehörkomponente durch die Kabellänge eingeschränkt ist, wobei das Kabel in Abhängigkeit von der Position der Zubehörkomponente entweder durchhängt oder unter Zug steht.

Aus der EP 2 722 584 A2 ist ein Beleuchtungsapparat bekannt, der eine Schieneneinheit und eine elektrische Einheit umfasst, die an der Schieneneinheit in einer verstellbaren Position befestigt werden kann und die Schieneneinheit elektrisch kontaktiert, wobei die elektrische Einheit eine Lichtquelle aufweist. Aus der CN 102 346 360 A sind Stützsysteme mit einer Haltestange zum Halten einer Zubehörkomponente relativ zu einer Filmkamera bekannt. Aus der US 4 699 484 A ist ein Schienensystem für eine elektromotorisch bewegliche Filmkamera bekannt, wobei die Schienen eine Vertiefung mit einem zurückversetzten, von außen zugänglichen Kontaktbereich zur elektrischen Kontaktierung aufweisen.

Es ist eine Aufgabe der Erfindung, ein Stützsystem mit einer Haltestange der eingangs genannten Art zu schaffen, bei der die genannten Probleme beseitigt sind. Insbesondere soll auf den Einsatz von Kabeln weitgehend verzichtet werden. Ferner sollen eine variable Positionierbarkeit sowie ein zuverlässiger Betrieb der Zubehörkomponente gewährleistet werden.

Die Aufgabe wird gelöst durch ein Stützsystem mit den Merkmalen des Anspruchs 1 oder des Anspruchs 2, durch die Verwendung einer Haltestange nach Anspruch und durch eine Zubehörkomponente nach Anspruch 17.

Bei dem Stützsystem weist die zum Halten der Zubehörkomponente ausgebildete Haltestange wenigstens eine nach außen geöffnete Vertiefung auf, wobei die Haltestange in der Vertiefung einen zurückversetzten, von außen zugänglichen Kontaktbereich zur elektrischen Kontaktierung der Zubehörkomponente aufweist.

Die Zubehörkomponente weist einen geeigneten Stromabnehmer auf, der in die Vertiefung der Haltestange eingreift und den Kontaktbereich elektrisch kontaktiert, wenn die Zubehörkomponente an der Haltestange mechanisch befestigt ist. Auf diese Weise kann die Zubehörkomponente auf einfache Weise und zuverlässig elektrisch versorgt bzw. gekoppelt werden. Eine umständliche Versorgung mittels Kabel und fehleranfälliger elektrischer Steckverbindungen ist nicht mehr notwendig. Ferner kann die Zubehörkomponente in Abhängigkeit von der Vertiefung variabel positioniert werden.

Die Erfindung beruht auf der Erkenntnis, dass eine oder mehrere elektrische Versorgungsleitungen für eine bzw. mehrere Zubehörkomponenten der Filmkamera vorteilhaft in die Haltestange integriert werden können, die zum Halten der jeweiligen Zubehörkomponente relativ zu der Filmkamera ohnehin vorgesehen ist. Die Haltestange vereint somit mechanische und elektrische Zwecke und stellt eine innovative elektromechanische Einrichtung dar, die für das Ankoppeln von Zubehörkomponenten an eine Filmkamera den Einsatz von Kabeln weitgehend überflüssig macht und einen zuverlässigeren und sichereren Betrieb von Zubehörkomponenten gewährleistet, wie im Folgenden noch genauer beschrieben wird.

Durch die Tatsache, dass der Kontaktbereich in der Vertiefung zurückversetzt ist, wird der Kontaktbereich vor unerwünschten elektrischen Kontakten mit anderen Komponenten oder Bauteilen der Filmkamera geschützt. Insbesondere wird das Risiko einer ungewollten Berührung des Kontaktbereichs durch einen Bediener der Filmkamera reduziert. Vorzugsweise ist die Vertiefung in Länge, Breite und Tiefe derart dimensioniert, dass eine Berührung des Kontaktbereichs, insbesondere durch einen Bediener, praktisch ausgeschlossen werden kann. Vorzugsweise ist der Kontaktbereich zumindest von der äußeren Oberfläche der Haltestange elektrisch isoliert, sodass die Haltestange keine exponierten Bereiche aufweist, die zu einem elektrischen Kurzschluss führen könnten.

Die elektrische Kontaktierung der Zubehörkomponente über den Kontaktbereich kann zur elektrische Energieversorgung der Zubehörkomponente und/oder zur elektrischen Signalübertragung (z.B. Steuersignale, Daten) von und/oder zu der Zubehörkomponente dienen.

Bei dem Stützsystem gemäß Anspruch 1 sind die Haltestangen dazu ausgebildet, an einer Befestigungseinrichtung, vorzugsweise einer herkömmlichen Befestigungsbrücke (übliche Bezeichnung: "bridge plate") befestigt zu werden. Hierbei ist eine paarweise Anordnung von zwei Haltestangen nebeneinander vorgesehen, wobei entweder nur eine oder beide der zwei Haltestangen mit der Vertiefung und dem darin vorgesehenen elektrischen Kontaktbereich ausgestattet sein kann/können.

Bei dem Stützsystem gemäß Anspruch 2 ist die Haltestange zur Befestigung in einer anderen Konfiguration und/oder Position an bzw. relativ zu der Filmkamera ausgebildet, nämlich an einem die Filmkamera umgebenden Käfig (übliche Bezeichnung: "cage"), insbesondere um eine andersartige Zubehörkomponente zu halten, z.B. ein Display oder ein Entfernungsmessgerät.

Die zum Halten der Zubehörkomponente ausgebildete Haltestange kann durch eine massive Stange, durch ein hohles Rohr oder durch ein Rohr mit Innenstruktur gebildet sein, wobei die Vertiefung an der Stange bzw. dem Rohr ausgebildet ist. Vorzugsweise erstreckt sich die Haltestange linear (geradlinig), d.h. nicht gekrümmt. Ein hohles Rohr mit Innenstruktur kann beispielsweise dergestalt gebildet sein, dass wenigstens ein Verbindungssteg zwischen zwei Innenumfangsabschnitten des hohlen Rohrs vorgesehen ist. Ein solches Rohr mit Innenstruktur kann etwa durch ein Extrusionsverfahren hergestellt werden. Es versteht sich, dass die zum Halten der Zubehörkomponente ausgebildete Haltestange entlang der Längsachse nicht ausschließlich massiv oder hohl ausgebildet sein muss. So kann die Struktur der Haltestange entlang der Längsachse variabel sein. Beispielsweise kann die massive Stange abschnittsweise ausgefräst sein, um das Gewicht der Haltestange zu reduzieren und/oder die mechanischen Eigenschaften der Haltestange zu verbessern.

Die zum Halten der Zubehörkomponente ausgebildete Haltestange kann aus geeigneten Materialien gebildet sein, etwa aus einem Metall (z.B. Stahl) bzw. einem Leichtmetall (z.B. Aluminium). Die Haltestange muss nicht elektrisch leitend sein. In Frage kommen somit auch biegesteife Kunststoffe, insbesondere Carbon und dergleichen. Denkbar sind auch Mischformen, z.B. in Gestalt eines in Längsrichtung geschlitzten, hohlen Metallrohrs, in dem zur mechanischen Stabilisierung ein oder mehrere z.B. aus Kunststoff gebildete Einsätze eingebracht sind.

Vorzugsweise weist die zum Halten der Zubehörkomponente ausgebildete Haltestange einen zumindest im Wesentlichen kreisförmigen Querschnitt auf, der entlang der Längsachse der Haltestange über die gesamte Länge oder abschnittsweise konstant ist. Der Querschnitt kann abgesehen von der Vertiefung vollständig kreisrund sein. Ein kreisrunder Querschnitt bietet im Hinblick auf die Stabilität der Haltestange und die Befestigung der Zubehörkomponente besondere Vorteile. So kann die Zubehörkomponente vorteilhaft mittels einer Klemmvorrichtung an der Haltestange mit kreisrundem Querschnitt befestigt werden. Der Querschnitt der Haltestange muss aber nicht streng kreisrund sein. Denkbar sind insbesondere ovale oder mehreckige, z.B. viereckige, sechseckige oder achteckige Querschnitte. Der in Längsrichtung konstante Querschnitt ist im Hinblick auf eine freie Positionierbarkeit der Zubehörkomponente sinnvoll. Hiervon kann aber abgewichen werden. Beispielsweise kann die zum Halten der Zubehörkomponente ausgebildete Haltestange lediglich abschnittsweise mit einem kreisrunden Querschnitt versehen werden, um diskrete Befestigungspositionen für die Zubehörkomponente zu definieren. Ferner kann der Querschnitt, insbesondere der Durchmesser, der Haltestange abschnittsweise unterschiedlich sein, um eine Kompatibilität mit unterschiedlichen Zubehörkomponenten und/oder Stützsystemen und/oder Befestigungsplatten zu gewährleisten. Vorzugsweise weist der Querschnitt in Umfangsrichtung und/oder in Längsrichtung einen glatten Verlauf auf. Auf diese Weise werden störende Scharfkanten vermieden und die mechanischen Eigenschaften der Haltestange nicht nachteilig beeinflusst.

Nach einer bevorzugten Ausführungsform ist die Vertiefung länglich ausgebildet und erstreckt sich entlang der Längsachse der Haltestange. Die Vertiefung kann eine Nut bilden. Die Zubehörkomponente kann somit zumindest entlang der länglichen Vertiefung frei positioniert und gleichzeitig über einen in die Vertiefung eingreifenden Stromabnehmer elektrisch versorgt werden. Vorzugsweise ist die Vertiefung derart schmal ausgebildet, dass eine unerwünschte Kontaktierung des Kontaktbereichs praktisch ausgeschlossen ist. Hierfür kann die Nut eine Breite von weniger als 1cm, vorzugsweise weniger als 0.5 cm aufweisen.

Die Vertiefung kann insbesondere durch eine im Wesentlichen T-förmige Nut gebildet sein. Auf diese Weise kann zwischen dem Kontaktbereich und der äußeren Umgebung der Haltestange ein besonders schmaler Übergangsbereich vorgesehen werden (entsprechend dem mittleren Steg der "T"-Form), wodurch das Risiko ungewollter elektrischer Kontakte weiter verringert wird. Der Kontaktbereich kann jedoch breiter als dieser Übergangsbereich ausgebildet sein, sodass ein in die Vertiefung eingreifender Stromabnehmer der Zubehörkomponente den Kontaktbereich sicher und ohne Verkanten kontaktieren kann. Ferner kann durch die T-förmige Nut eine Kontaktplatine sicher in der Vertiefung gehalten werden.

Gemäß einer weiteren Ausführungsform weist die zum Halten der Zubehörkomponente ausgebildete Haltestange an verschiedenen Umfangsabschnitten zwei nach außen geöffnete Vertiefungen auf, wobei die Haltestange in jeder der zwei Vertiefungen einen zurückversetzten, von außen zugänglichen Kontaktbereich zur elektrischen Kontaktierung der Zubehörkomponente aufweist. Die Zubehörkomponente kann somit in Abhängigkeit der Vertiefungen in unterschiedlichen Winkelstellungen an der Haltestange befestigt werden. Mehrere Vertiefungen sind insbesondere dann vorteilhaft, wenn mehrere Zubehörkomponenten mit jeweils festem Stromabnehmer in unterschiedlichen Winkelstellungen an derselben Haltestange montiert werden sollen. Denkbar sind auch Zubehörkomponenten mit jeweils zwei separaten Stromabnehmern, die jeweils in eine zugeordnete Vertiefung der Haltestange eingreifen und einen jeweiligen Kontaktbereich kontaktieren. Die Vertiefungen können an zwei einander diametral gegenüber liegenden (d.h. um einen Umfangswinkel von 180° zueinander versetzten) Umfangsabschnitten der Haltestange ausgebildet sein. Die Kontaktbereich der ersten Vertiefung kann für den Plus-Pol und der Kontaktbereich der zweiten Vertiefung für den Minus-Pol einer elektrischen Versorgung der Zubehörkomponente vorgesehen sein. Denkbar ist auch, eine der beiden Vertiefungen ausschließlich für eine Datenübertragung zu nutzen.

Nach einer bevorzugten Ausführungsform ist in der Vertiefung - im Falle von mehreren Vertiefungen in jeder Vertiefung - wenigstens eine Kontaktplatine angeordnet, an der der Kontaktbereich ausgebildet ist. Die Kontaktplatine kann als separates Bauteil unabhängig von der Haltestange hergestellt werden und in die Vertiefung eingesetzt werden. Die Herstellung der Haltestange ist somit wesentlich vereinfacht, wobei die Kontaktplatine bei einem später auftretenden Defekt einfach ausgetauscht werden kann. Es ist jedoch auch denkbar, den Kontaktbereich integral an der Haltestange auszubilden, z.B. an einem zumindest abschnittsweise elektrisch leitfähigen Boden der Vertiefung. Zusätzlich zu dem Kontaktbereich, d.h. zu den erforderlichen Mitteln für die elektrische Kontaktierung, kann die jeweilige Kontaktplatine auch eine Steuerschaltung und/oder Sensorik aufweisen, wie nachfolgend noch erläutert wird. Eine derartige Steuerschaltung und/oder Sensorik kann bezüglich des Kontaktbereichs beispielsweise an einer Unterseite der jeweiligen Kontaktplatine angeordnet sein.

Der Begriff "Kontaktplatine" ist im Zusammenhang mit der Erfindung breit zu verstehen und umfasst nicht nur ein sogenanntes "printed circuit board" (PCB), sondern jegliche Trägereinrichtung, die die Position des genannten Kontaktbereichs innerhalb der Vertiefung der Haltestange festlegt und die wenigstens einen elektrischen Anschluss aufweist.

Die Vertiefung der Haltestange kann entlang der Längsachse der Haltestange zumindest abschnittsweise wenigstens eine Hinterschneidung aufweisen, wobei die Kontaktplatine zwischen einem Boden der Vertiefung und der Hinterschneidung gefangen ist. Auf diese Weise kann die Kontaktplatine zusätzlich oder alternativ zu einer Klebeverbindung in der Vertiefung fixiert werden. Die Kontaktplatine verleibt somit auch dann in einer gewünschten Position, wenn eine Klebeverbindung z.B. nach einer langen Lebensdauer versagen sollte. Die Kontaktplatine kann durch zwei in der Vertiefung einander gegenüberliegende Nuten geführt sein, wobei die Kontaktplatine in Längsrichtung in die Vertiefung eingeschoben werden kann.

Nach einer weiteren Ausführungsform ist die Vertiefung entlang der Längsachse der Haltestange, insbesondere ausschließlich, durch Seitenflächen begrenzt, die relativ zu der Erstreckungsebene der Kontaktplatine geneigt sind und nach außen weisen. Die geneigten Seitenflächen können eine reibungsarme Führung eines in die Vertiefung eingreifenden Stromabnehmers der Zubehörkomponente begünstigen und somit als Einführhilfe dienen. Ferner wird das Risiko eines Verkantens eines Stromabnehmers insbesondere in solchen Fällen verringert, in denen der Stromabnehmer nicht exakt senkrecht zur Erstreckungsebene der Kontaktplatine in die Vertiefung eingreift.

Die vorstehend für den Fall einer Vertiefung geschilderten Merkmale können bei mehreren Vertiefungen, insbesondere bei allen vorgesehenen Vertiefungen, in entsprechender Weise verwirklicht sein.

Die Kontaktplatine kann einen elektrischen Anschluss zum Anschließen der Kontaktplatine an eine Steuerschaltung aufweisen. Die Steuerschaltung kann in die Haltestange integriert oder extern von dieser vorgesehen sein. Ferner können elektrische Anschlüsse vorgesehen sein, um die Kontaktplatine an elektrische Versorgungseinrichtungen oder andere Steuerungseinrichtungen anzubinden. Gemäß einer alternativen Ausführungsform kann die Steuerschaltung jedoch auch an der jeweiligen Kontaktplatine bzw. an einer von mehreren Kontaktplatinen vorgesehen sein.

Gemäß einer weiteren Ausführungsform ist die zum Halten der Zubehörkomponente ausgebildete Haltestange unterhalb eines Bodens der Vertiefung zumindest abschnittsweise hohl ausgebildet. Neben einer Gewichtsreduktion der Haltestange kann hierdurch auch einer übermäßigen Erwärmung der Kontaktplatine entgegengewirkt werden.

Im Folgenden werden beispielhaft mögliche Ausgestaltungen des Kontaktbereichs beschrieben.

Gemäß einer Ausführungsform umfasst der Kontaktbereich mehrere zueinander benachbarte, sich entlang der Längsachse der Haltestange erstreckende Kontaktbahnen, die elektrisch voneinander isoliert sind. Somit kann jede Kontaktbahn unabhängig von anderen Kontaktbahnen zur elektrischen Versorgung einer an der Haltestange befestigten Zubehörkomponente herangezogen werden. Selbstverständlich können einzelne oder mehrere Kontaktbahnen zur Versorgung einzelner Zubehörkomponenten oder zur gemeinschaftlichen Versorgung mehrerer Zubehörkomponenten dienen. Eine Kontaktbahn kann sowohl zur Spannungsversorgung als auch zur Datenübertragung vorgesehen sein. Es versteht sich, dass nicht sämtliche der mehreren Kontaktbahnen zeitgleich an eine elektrische Versorgung angeschlossen sein müssen. So kann beispielsweise vorgesehen sein, dass die Kontaktbahnen selektiv elektrisch geschaltet, d.h. aktiviert werden können.

Gemäß einer Ausführungsform kann wenigstens eine der mehreren Kontaktbahnen sich zumindest im Wesentlichen über die gesamte Länge der Haltestange erstrecken. Es ist auch möglich, dass sämtliche der mehreren Kontaktbahnen sich zumindest im Wesentlichen über die gesamte Länge der Haltestange erstrecken. Die Kontaktbahnen können insbesondere eine jeweilige Busleitung bilden, wie nachfolgend noch erläutert wird.

Der Kontaktbereich kann gemäß einer alternativen Ausführungsform entlang der Längsachse der Haltestange in mehrere Kontaktsektionen unterteilt sein, die elektrisch voneinander isoliert sind. Die Kontaktsektionen können ebenso wie die Kontaktbahnen unabhängig voneinander verwendet werden, also z.B. selektiv elektrisch aktiv bzw. inaktiv geschaltet werden. Die Kontaktsektionen des Kontaktbereichs können gemäß einem Raster verteilt sein, insbesondere in regelmäßiger Anordnung. Die Unterteilung entlang der Längsachse der Haltestange kann sich insbesondere auf eine oder mehrere der genannten Kontaktbahnen beziehen. So kann der Kontaktbereich insbesondere eine oder mehrere Kontaktbahnen aufweisen, die entsprechend in Kontaktsektionen unterteilt sind, wie nachstehend noch erläutert wird.

Gemäß einer weiteren Ausführungsform umfasst die zum Halten der Zubehörkomponente ausgebildete Haltestange eine Sensorik zur Erfassung der Anwesenheit und/oder der Position und/oder eines Identifikationsmerkmals einer von der Haltestange gehaltenen Zubehörkomponente. Eine Anwesenheits- und/oder Positionserfassung kann insbesondere zur selektiven Freigabe bzw. Aktivierung einzelner Kontaktbahnen oder Kontaktsektionen verwendet werden. Ein oder mehrere Identifikationsmerkmale (z.B. Art bzw. Typ der Zubehörkomponente oder Seriennummer) können zum Identifizieren einer speziellen Zubehörkomponente dienen, wodurch z.B. eine spezifische Ansteuerung der Zubehörkomponente ermöglicht werden kann. Ferner kann der Betrieb einer Filmkamera in Abhängigkeit einer identifizierten Zubehörkomponente automatisch angepasst werden. Die Sensorik kann zu diesem Zweck mit einer der Haltestange zugeordneten Steuerschaltung verbunden sein.

Die Sensorik kann wenigstens einen Sensor aufweisen, der einen Hall-Sensor, einen Reed-Schalter, einen elektrischen Kontaktschalter, einen mechanischen Kontaktschalter, und/oder einen Funkfrequenzempfänger umfasst. Der Funkfrequenzempfänger kann insbesondere ein RFID (Radio-Frequency-Identification)-Leser, z.B. auf Basis des NFC (Near-Field-Communication)-Standards, sein. Der Sensor kann insbesondere dazu vorgesehen sein, ein Magnetfeld eines Permanentmagneten der Zubehörkomponente, eine mechanische Betätigung durch die Zubehörkomponente, eine elektrische Verbindung zu der Zubehörkomponente und/oder ein Antwortsignal eines passiven Funkfrequenzempfängers (z.B. eines RFID-Transponders) der Zubehörkomponente und/oder das Steuersignal eines aktiven Funkfrequenzsenders der Zubehörkomponente zu detektieren. Auf diese Weise kann die elektrische Anbindung der Zubehörkomponente an die Filmkamera völlig automatisch erfolgen und somit für den Benutzer besonders komfortabel und fehlersicher sein. Eine manuelle Anbindung oder Installation der Zubehörkomponente, die spezielles Wissen des Benutzers erfordern würde, ist nicht erforderlich.

Gemäß einer weiteren Ausführungsform ist der Kontaktbereich - wie bereits erläutert - entlang der Längsachse der Haltestange in mehrere elektrisch voneinander isolierte Kontaktsektionen unterteilt, wobei die zum Halten der Zubehörkomponente ausgebildete Haltestange wenigstens eine Steuerschaltung aufweist, die dazu konfiguriert ist, in Abhängigkeit von der erfassten Anwesenheit und/oder Position und/oder dem erfassten Identifikationsmerkmal der von der Haltestange gehaltenen Zubehörkomponente wenigstens eine der mehreren Kontaktsektionen für eine elektrische Energieversorgung der Zubehörkomponente und/oder für eine elektrische Signalübertragung von oder zu der Zubehörkomponente selektiv zu aktivieren. Mit anderen Worten kann die Steuerschaltung dazu ausgebildet sein, in Abhängigkeit von einem Signal, welches von der genannten Sensorik erzeugt und an die Steuerschaltung übermittelt wird, individuelle Kontaktsektionen der Haltestange elektrisch aktiv zu schalten, insbesondere für die Dauer des Empfangs des Signals der Sensorik oder für eine vorbestimmte Dauer.

Beispielsweise kann die Steuerschaltung dazu konfiguriert sein, einen elektrischen Kontakt zwischen einer Kontaktsektion und einem Kontaktnehmer einer Zubehörkomponente zu detektieren und im Falle einer Detektion die Zubehörkomponente über die detektierte Kontaktsektion elektrisch zu versorgen. Andere Kontaktsektionen, die nicht für eine elektrische Versorgung einer Zubehörkomponente benötigt werden, können insbesondere aus Sicherheitsgründen deaktiviert bleiben. Die Kontaktsektionen können wie oben erwähnt gemäß einem Raster verteilt sein, insbesondere in regelmäßiger Anordnung. Die Rasterung kann insbesondere derart ausgestaltet sein, dass eine unbeabsichtigte Kontaktierung einer durch eine Zubehörkomponente aktivierten Kontaktsektion aufgrund der Größe der Zubehörkomponente praktisch ausgeschlossen ist. Mit anderen Worten kann z.B. die Länge einzelner Kontaktsektionen an die Größe eines Stromabnehmers und/oder der Zubehörkomponente selbst angepasst sein. Ferner versteht es sich, dass der Kontaktbereich insbesondere eine oder mehrere Kontaktbahnen aufweisen kann, die entlang der Längsachse der Haltestange entsprechend in Kontaktsektionen unterteilt sind.

Zur selektiven Aktivierung einzelner Kontaktsektionen kann eine (zentrale) Steuerschaltung für mehrere, insbesondere sämtliche der mehreren Kontaktsektionen, oder jeweils eine eigene (dezentrale) Steuerschaltung für jede einzelne Kontaktsektion vorgesehen sein. Eine jeweilige Steuerschaltung muss jedoch nicht Bestandteil der Haltestange sein. Die Steuerschaltung kann vielmehr auch eine externe Einrichtung sein, z.B. als Teil der Steuereinheit der Filmkamera.

Nach einer weiteren Ausführungsform weist die zum Halten der Zubehörkomponente ausgebildete Haltestange wenigstens eine elektrische Busleitung auf, die sich entlang der mehreren Kontaktsektionen durchgehend erstreckt, um die mehreren Kontaktsektionen mit elektrischer Energie zu versorgen und/oder um elektrische Signale von und zu den mehreren Kontaktsektionen zu übertragen. Die Versorgung der Kontaktsektionen kann somit besonders effizient bewerkstelligt werden. Die Busleitung kann vorzugsweise nach außen verdeckt ausgebildet und/oder angeordnet sein. Insbesondere kann die Busleitung an der Unterseite der genannten Kontaktplatine vorgesehen sein.

Vorzugsweise weist die zum Halten der Zubehörkomponente ausgebildete Haltestange wenigstens eine elektrische Schnittstelle zum Verbinden des Kontaktbereichs mit einer elektrischen Energiequelle und/oder mit einer externen Kommunikationseinrichtung auf. Die Schnittstelle kann beispielsweise ein elektrischer Steckverbinder sein. Die Haltestange kann somit leicht bei bereits bestehenden Systemen nachgerüstet werden, wobei die Haltestange beispielsweise mit einem Akkumulator und/oder einer Steuereinheit der Filmkamera elektrisch verbunden werden kann. Die Schnittstelle kann auch in einen mechanischen Anschluss der Haltestange integriert sein.

Gemäß einer weiteren Ausführungsform umfasst der Kontaktbereich eine Kontaktbahn, die sich wie bereits erläutert entlang der Längsachse der Haltestange erstreckt, wobei die Kontaktbahn einen ersten elektrischen Anschluss für eine elektrische Energieversorgung der Zubehörkomponente und/oder für eine elektrische Signalübertragung von oder zu der Zubehörkomponente bildet.

Darüber hinaus kann bei einem Stützsystem, welches wenigstens zwei Haltestangen umfasst, die Kontaktbahn einer im Übrigen gleichartigen weiteren Haltestange einen zweiten elektrischen Anschluss für die elektrische Energieversorgung der Zubehörkomponente und/oder für die elektrische Signalübertragung von oder zu der Zubehörkomponente bilden. Mit anderen Worten können zwei Haltestangen jeweils einen durch eine jeweilige Kontaktbahn gebildeten elektrischen Anschluss für die Zubehörkomponente umfassen, wobei die Zubehörkomponente mit beiden Haltestangen zumindest elektrisch verbunden ist. Die beiden Anschlüsse können beispielsweise einen Plus-Pol und einen Minus-Pol einer elektrischen Spannungsversorgung bilden. Da die Anschlüsse in diesem Fall an separaten Haltestangen vorgesehen werden sind, kann die Kurzschlussgefahr zwischen den Anschlüssen minimiert werden. Die Zuordnung der Anschlüsse zu den elektrischen Polen kann für einen Benutzer z.B. durch eine mechanische Kodierung der betreffenden Haltestangen erleichtert werden.

Als Alternative oder Ergänzung zu zwei einen jeweiligen elektrischen Anschluss aufweisenden Haltestangen kann die einzelne Haltestange selbst elektrisch leitend ausgebildet sein (insbesondere an einer Außenfläche), wobei die Haltestange (bzw. deren Außenfläche) einen zweiten elektrischen Anschluss für die elektrische Energieversorgung der Zubehörkomponente und/oder für die elektrische Signalübertragung von oder zu der Zubehörkomponente bildet. Beispielsweise kann die Haltestange als elektrischer Masseanschluss dienen, wodurch eine separate Masseleitung eingespart werden kann.

Sowohl die Kontaktbahn einer einzelnen Haltestange als auch die Kontaktbahn einer weiteren gleichartigen Haltestange können entlang der Längsachse der jeweiligen Haltestange in mehrere elektrisch voneinander isolierte Kontaktsektionen unterteilt und wie vorstehend beschrieben selektiv aktivierbar sein. Im Hinblick auf die vorstehend beschriebene Sensorik kann diese im Fall von zwei zur elektrischen Versorgung beitragenden Haltestangen auf eine Haltestange beschränkt sein, wobei z.B. die an einer Haltestange erfasste Position zur Freischaltung bzw. Aktivierung der von der erfassten Position abhängigen Kontaktsektionen beider Haltestangen herangezogen werden kann. Es ist also nur eine Sensorik und ein Erfassungsvorgang notwendig, um die relevanten Kontaktsektionen der zwei Haltestangen mittels einer oder mehrerer Schalteinrichtungen freizuschalten.

Gemäß einer bevorzugten Ausführungsform umfasst der Kontaktbereich wenigstens eine erste Kontaktbahn und eine zweite Kontaktbahn, die sich entlang der Längsachse der Haltestange erstrecken. Bei dieser Ausführungsform können also zwei oder mehr (z.B. drei oder vier) elektrisch voneinander isolierte Kontaktbahnen innerhalb einer gemeinsamen Vertiefung angeordnet sein und dort von einem mehrpoligen Stromabnehmer einer Zubehörkomponente kontaktiert werden. Die zweite Kontaktbahn verläuft vorzugsweise neben der ersten Kontaktbahn. Die erste Kontaktbahn kann einen ersten elektrischen Anschluss und die zweite Kontaktbahn einen zweiten elektrischen Anschluss für eine elektrische Energieversorgung der Zubehörkomponente und/oder für eine elektrische Signalübertragung von oder zu der Zubehörkomponente bilden. Die erste Kontaktbahn und/oder die zweite Kontaktbahn können entlang der Längsachse der Haltestange in mehrere elektrisch voneinander isolierte Kontaktsektionen unterteilt sein. Wie vorstehend beschrieben, kann eine selektive Aktivierung einzelner Kontaktsektionen mittels einer Sensorik und einer Steuerschaltung erfolgen.

Ein besonders einfacher Aufbau mit vollem Funktionsumfang und geringer Gefahr eines elektrischen Kurzschlusses ergibt sich beispielsweise, wenn die erste Kontaktbahn entlang der Längsachse der Haltestange durchgehend verläuft, um einen ersten elektrischen Anschluss für eine elektrische Energieversorgung der Zubehörkomponente und/oder für eine elektrische Signalübertragung von oder zu der Zubehörkomponente zu bilden, und wenn die zweite Kontaktbahn entlang der Längsachse der Haltestange in mehrere elektrisch voneinander isolierte Kontaktsektionen unterteilt ist und mittels einer Steuerschaltung selektiv aktiviert werden kann, um einen zweiten elektrischen Anschluss für eine elektrische Energieversorgung der Zubehörkomponente und/oder für eine elektrische Signalübertragung von oder zu der Zubehörkomponente zu bilden. Hierbei kann eine verdeckt liegende Versorgungsleitung für die mehreren Kontaktsektionen vorgesehen sein, beispielsweise in Form der genannten Busleitung an der Unterseite der genannten Kontaktplatine.

Gemäß einer weiteren Ausführungsform weist die zum Halten der Zubehörkomponente ausgebildete Haltestange, wie bereits erläutert, an einem ersten Umfangsabschnitt eine erste Vertiefung mit einem ersten Kontaktbereich und an einem zweiten Umfangsabschnitt eine zweite Vertiefung mit einem zweiten Kontaktbereich auf, wobei der erste Kontaktbereich einen ersten elektrischen Anschluss und der zweite Kontaktbereich einen zweiten elektrischen Anschluss für eine elektrische Energieversorgung der Zubehörkomponente und/oder für eine elektrische Signalübertragung von oder zu der Zubehörkomponente bilden. Es kann somit eine örtliche Separierung von zwei elektrischen Anschlüssen an einer einzelnen Haltestange verwirklicht sein. Die beiden elektrischen Anschlüsse können insbesondere diametral gegenüber liegend vorgesehen sein. Der erste Kontaktbereich und/oder der zweite Kontaktbereich können entlang der Längsachse der Haltestange in mehrere elektrisch voneinander isolierte Kontaktsektionen unterteilt sein. Wie vorstehend beschrieben, kann eine selektive Aktivierung einzelner Kontaktsektionen mittels einer Sensorik und einer Steuerschaltung erfolgen.

Sofern im Zusammenhang mit der Erfindung eine Kontaktbahn, ein Kontaktbereich oder die Haltestange selbst einen elektrischen Anschluss bilden soll, ist hierunter zu verstehen, dass die betreffende Kontaktbahn, der Kontaktbereich oder die Haltestange dazu ausgebildet ist, an ein zugeordnetes elektrisches Potential angeschlossen zu werden, um eine Energieversorgung und/oder eine Signalübertragung zu ermöglichen, wobei die physische Ankopplung nicht unmittelbar an der betreffenden Kontaktbahn, den Kontaktbereich oder der Haltestange erfolgen muss, sondern auch eine indirekte Ankopplung möglich ist (z.B. über einen Steckverbinder oder eine sonstige elektrische Schnittstelle).

Gemäß einer weiteren Ausführungsform weist die zum Halten der Zubehörkomponente ausgebildete Haltestange entlang ihrer Längsachse mehrere nach außen geöffnete Vertiefungen auf. Die mehreren Vertiefungen können entlang der Längsachse hintereinander in derselben Winkelausrichtung an der Haltestange vorgesehen sein. Die Haltestange kann in jeder der mehreren Vertiefungen einen jeweiligen zurückversetzten, von außen zugänglichen Kontaktbereich zur elektrischen Kontaktierung einer Zubehörkomponente aufweisen. Der jeweilige Kontaktbereich kann insbesondere eine Kontaktbahn oder wenigstens zwei (z.B. zwei, drei oder vier) nebeneinander verlaufende Kontaktbahnen umfassen. Die mehreren Vertiefungen bzw. Kontaktbereiche können gemäß einem Raster, insbesondere in regelmäßiger Anordnung entlang der Längsachse und in Flucht zueinander, verteilt sein. Eine jeweilige Vertiefung kann hierbei eine Montageposition für eine Zubehörkomponente definieren. Dies kann zur Vermeidung von Fehlmontagen z.B. dann sinnvoll sein, wenn eine Zubehörkomponente baubedingt nur an einer durch eine jeweilige Vertiefung bestimmten Position befestigt werden soll. Die Vertiefung kann in diesem Fall gleichzeitig eine mechanische Kodierung für den Benutzer repräsentieren, sodass dieser eine betreffende Zubehörkomponente besonders schnell und fehlerfrei an der Haltestange befestigen kann. Es können auch mehrere, beispielsweise zwei, derartige Reihen von Vertiefungen vorgesehen sein, die relativ zueinander in verschiedenen Winkelausrichtungen, d.h. an verschiedenen Umfangsabschnitten der Haltestange, angeordnet sind.

Insbesondere im Falle mehrerer Vertiefungen ist es denkbar, dass diese unterschiedlich zueinander ausgebildet sind. Die unterschiedlichen Vertiefungen können insbesondere dazu angepasst sein, ausschließlich mit jeweils zugeordneten Zubehörkomponenten, insbesondere mit einem zugeordneten Stromabnehmer, kompatibel zu sein. Beispielsweise kann eine bestimmt Art von Zubehörkomponenten nur im Bereich einer zugeordneten Vertiefung montierbar sein.

Die zum Halten der Zubehörkomponente ausgebildete Haltestange kann dazu ausgebildet sein, mit weiteren gleichartigen Haltestangen mechanisch und elektrisch gekoppelt zu werden. Beispielsweise kann die Haltestange durch weitere Haltestangen verlängert werden, um die Länge der Haltestange z.B. an eine Filmkamera und/oder an ein Stützsystem der Filmkamera anzupassen. Denkbar sind auch ausziehbare Haltestangen.

Bei dem Stützsystem, welches wenigstens zwei Haltestangen und eine Befestigungseinrichtung zum Befestigen der zwei Haltestangen an einer Filmkamera umfasst, wobei wenigstens eine der zwei Haltestangen gemäß einer der vorstehend beschriebenen Ausführungsformen ausgebildet ist, kann die Befestigungseinrichtung als eine von der Filmkamera separate Platte ausgeführt oder in die Filmkamera integriert sein.

Wie bereits erläutert, kann bei einem derartigen Stützsystem ein Element (z.B. Kontaktbereich) der einen Haltestange einen ersten elektrischen Anschluss für die elektrische Energieversorgung der Zubehörkomponente und/oder für die elektrische Signalübertragung von oder zu der Zubehörkomponente bilden, und ein Element (zum Beispiel Kontaktbereich) der anderen Haltestange kann einen zweiten elektrischen Anschluss bilden.

Die oben beschriebene Steuerschaltung zur Aktivierung von Kontaktsektionen kann Teil des genannten Stützsystems sein. In einer solchen Ausführungsform kann die wenigstens eine Haltestange des Stützsystems eine Sensorik zur Erfassung der Anwesenheit und/oder der Position und/oder eines Identifikationsmerkmals einer von der Haltestange gehaltenen Zubehörkomponente umfassen, wobei der Kontaktbereich der wenigstens einen Haltestange entlang der Längsachse der Haltestange in mehrere elektrisch voneinander isolierte Kontaktsektionen unterteilt ist, und wobei das Stützsystem wenigstens eine Steuerschaltung aufweist, die dazu konfiguriert ist, in Abhängigkeit von einer erfassten Anwesenheit und/oder Position und/oder einem erfassten Identifikationsmerkmal der von der Haltestange gehaltenen Zubehörkomponente wenigstens eine der mehreren Kontaktsektionen für eine elektrische Energieversorgung der Zubehörkomponente und/oder für eine elektrische Signalübertragung von oder zu der Zubehörkomponente selektiv zu aktivieren.

Dier Erfindung bezieht sich gemäß Anspruch 16 auch auf die Verwendung einer Haltestange zum Halten einer Zubehörkomponente für eine Filmkamera.

Dier Erfindung bezieht sich ferner auf eine Zubehörkomponente für eine Filmkamera mit den Merkmalen des Anspruchs 17. Die Zubehörkomponente umfasst eine Befestigungseinrichtung, die dazu konfiguriert ist, die Zubehörkomponente in einer variablen Position entlang einer Längsachse einer Haltestange zu befestigen, und einen elektrischen Stromabnehmer, der dazu konfiguriert ist, in eine Vertiefung der Haltestange einzugreifen, um einen in der Vertiefung befindlichen Kontaktbereich elektrisch zu kontaktieren. Die Zubehörkomponente ist an eine Haltestange gemäß einer der vorstehend erläuterten Ausführungsformen angepasst sein. Der Stromabnehmer ist vorzugsweise wenigstens zweipolig. Eine einpolige Variante ist z.B. denkbar, wenn die Haltestange (insbesondere eine Außenfläche hiervon) einen zweiten elektrischen Anschluss bildet und die Zubehörkomponente mit der Haltestange elektrisch verbunden ist. Vorzugsweise ist der Stromabnehmer mit mehreren Polen ausgestattet, deren Anordnung an den Kontaktbereich, insbesondere an die Anordnung von Kontaktbahnen und/oder Kontaktsektionen, angepasst ist. Beispielsweise kann der Stromabnehmer vier Kontaktstifte aufweisen, die vier benachbarte Kontaktbahnen und/oder Kontaktsektionen kontaktieren.

Die Erfindung wird nachfolgend lediglich beispielhaft anhand der Zeichnungen erläutert. Es zeigen:
- Fig. 1: eine Haltestange zum Halten einer Zubehörkomponente relativ zu einer Filmkamera (Perspektivansicht);
- Fig. 2: die Haltestange von Fig. 1 und eine Zubehörkomponente, die nicht von der Haltestange gehalten wird (Frontansicht);
- Fig. 3: die Haltestange von Fig. 1 und die Zubehörkomponente von Fig. 2, die von der Haltestange gehalten wird (Perspektivansicht);
- Fig. 4: eine Filmkamera mit einer Befestigungseinrichtung, die Haltestange von Fig. 1 sowie eine Zubehörkomponente, die nicht von der Haltestange gehalten wird (Frontansicht);
- Fig. 5: die Anordnung von Fig. 4, wobei die Zubehörkomponente von der Haltestange gehalten wird;
- Fig. 6: die Anordnung von Fig. 5 in einer Seitenansicht;
- Fig. 7: die Anordnung von Fig. 5 und 6 in einer Perspektivansicht;
- Fig. 8: eine Haltestange zum Halten einer Zubehörkomponente relativ zu einer Filmkamera ohne Kontaktplatine in einer Draufsicht (Fig. 8a) und in einer Querschnittsansicht (Fig. 8b);
- Fig. 9: eine weitere Haltestange zum Halten einer Zubehörkomponente relativ zu einer Filmkamera ohne Kontaktplatine in einer Draufsicht (Fig. 9a) und in einer Querschnittsansicht (Fig. 9b);
- Fig. 10: eine weitere Haltestange zum Halten einer Zubehörkomponente relativ zu einer Filmkamera ohne Kontaktplatine in einer Draufsicht (Fig. 10a) und in einer Querschnittsansicht (Fig. 10b);
- Fig. 11: eine weitere Haltestange zum Halten einer Zubehörkomponente relativ zu einer Filmkamera ohne Kontaktplatine in einer Draufsicht (Fig. 11a) und in einer Querschnittsansicht (Fig. 11b);
- Fig. 12: eine weitere Haltestange zum Halten einer Zubehörkomponente relativ zu einer Filmkamera ohne Kontaktplatine in einer Draufsicht (Fig. 12a) und in einer Querschnittsansicht (Fig. 12b);
- Fig. 13: Draufsichten auf vier verschiedene Kontaktplatinen (Fig. 13a bis 13d) für eine Haltestange zum Halten einer Zubehörkomponente relativ zu einer Filmkamera;
- Fig. 14: ein Blockschaltbild einer Verschaltung mehrerer Kontaktsektionen.

In den Zeichnungen sind gleiche und gleichartige Teile mit denselben Bezugszeichen gekennzeichnet.

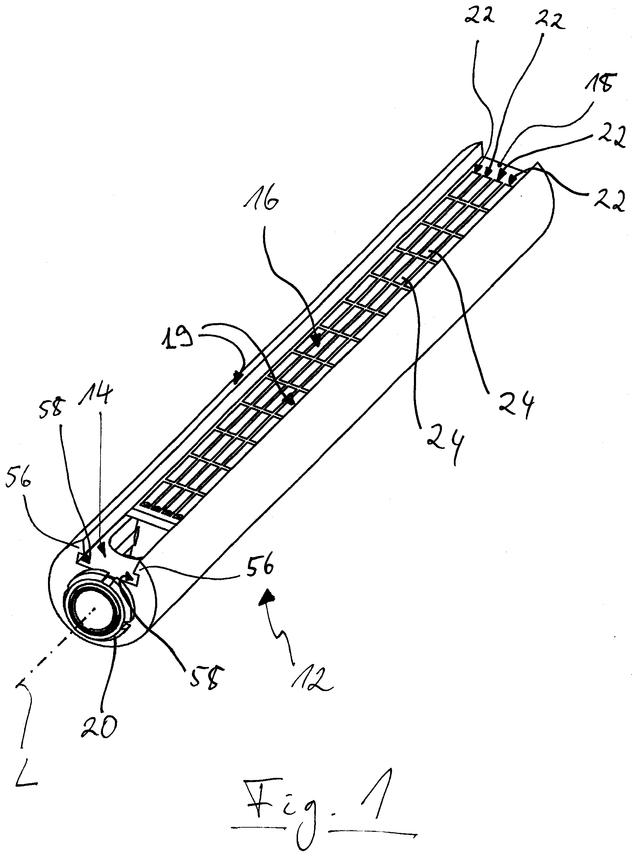

Fig. 1 zeigt eine Haltestange 12 zum Halten einer Zubehörkomponente relativ zu einer Filmkamera in einer variablen Position entlang einer Längsachse L der Haltestange 12, wobei die Haltestange 12 eine nach außen geöffnete Vertiefung 14 aufweist, und wobei die Haltestange 12 in der Vertiefung 14 einen zurückversetzten, von außen zugänglichen Kontaktbereich 16 zur elektrischen Kontaktierung der Zubehörkomponente aufweist, wie im Folgenden noch genauer erläutert wird.

In der Vertiefung 14 ist eine Kontaktplatine 18 angeordnet, wobei der Kontaktbereich 16 an der von außen zugänglichen Oberseite der Kontaktplatine 18 ausgebildet ist. Auf der Oberseite der Kontaktplatine 18 erstrecken sich parallel zur Längsachse L vier benachbart zueinander angeordnete Kontaktbahnen 22, die in regelmäßiger Rasterung entlang der Längsachse L in Kontaktsektionen 24 unterteilt sind. Sowohl die Kontaktbahnen 22 als auch die Kontaktsektionen 24 sind jeweils elektrisch voneinander isoliert. Insbesondere im Betriebsfall bzw. bei entsprechender Aktivierung können einzelne Kontaktbahnen 22 bzw. Kontaktsektionen 24 jedoch elektrisch miteinander verbunden sein. Die Haltestange 12 ist an einer Stirnseite mit einer elektrischen Schnittstelle in Form eines elektromechanischen Anschlussfortsatzes 20 versehen, wobei die Haltestange 12 über den Anschlussfortsatz 20 mit einer weiteren Haltestange 12 oder mit einer Befestigungseinrichtung (in Fig. 1 nicht gezeigt) mechanisch und elektrisch verbunden werden kann.

Die Vertiefung 14 erstreckt sich in Längsrichtung L mit konstantem Querschnitt, wobei die Vertiefung 14 zwei seitliche und gegenüberliegende Hinterschneidungen 56 aufweist, wodurch zwei seitliche und ebenfalls gegenüberliegende Nuten 58 gebildet sind. Im Ergebnis kann die Vertiefung 14 als eine T-Nut bezeichnet werden. Die Kontaktplatine 18 greift seitlich in die Nuten 58 ein, sodass die Kontaktplatine 18 in der Vertiefung 14 gefangen ist. Zur Herstellung der Haltestange 12 braucht die Kontaktplatine 18 lediglich in die Vertiefung 14 eingeschoben zu werden. Die Vertiefung 14 ist entlang der Längsachse L durch Seitenflächen 19 begrenzt, die relativ zur Erstreckungsebene der Kontaktplatine 18 geneigt sind und nach außen weisen.

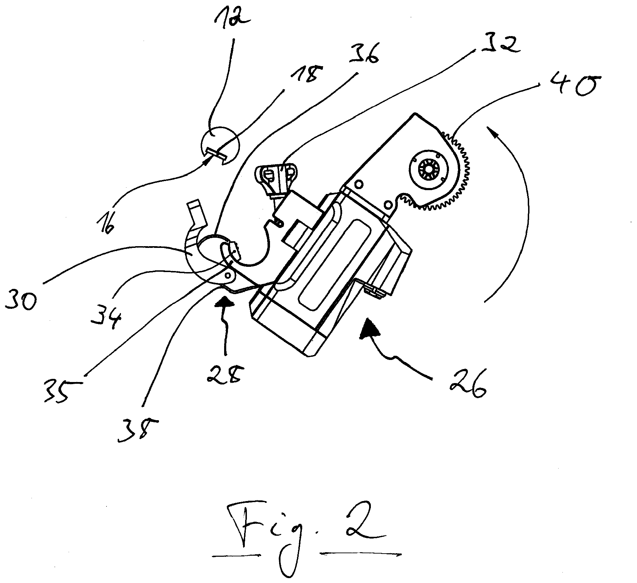

Fig. 2 zeigt die Haltestange 12 von Fig. 1 in einer Frontansicht, in einer Ansicht auf die Stirnseite der Haltestange 12, wobei der von außen zugänglichen Kontaktbereich im Wesentlichen nach unten weist. Ferner zeigt Fig. 2 eine Zubehörkomponente 26, die von der Haltestange 12 gehalten und zu diesem Zweck an der Haltestange 12 montiert werden soll. Hierfür weist die Zubehörkomponente 26 als Befestigungseinrichtung eine Schelle 28 auf, wobei ein Schwenkarm 30 der Schelle 28 in Fig. 2 geöffnet ist, um eine Aufnahme der Haltestange 12 in der Schelle 28 zu ermöglichen. An der gekrümmten Innenseite eines fest mit der Zubehörkomponente 26 verbundenen Abschnitts 35 der Schelle 28 ist ein Stromabnehmer 34 befestigt, welcher mittels flexibler Leitungen 36 und 38 mit der Zubehörkomponente elektrisch 26 verbunden ist. Ferner weist die Schelle 28 ein Verriegelungselement 32 in Form einer Knebelschraube auf, um den Schwenkarm 30 nach erfolgter Aufnahme der Haltestange 12 in der Schelle 28 in einer Verriegelungsstellung zu sichern. Bei der Zubehörkomponente 26 handelt es sich beispielhaft um einen Elektromotor, durch den ein Verstellring eines Objektivs einer Filmkamera über ein Antriebsrad 40 elektrisch verstellt werden kann, wie nachfolgend noch genauer erläutert wird.

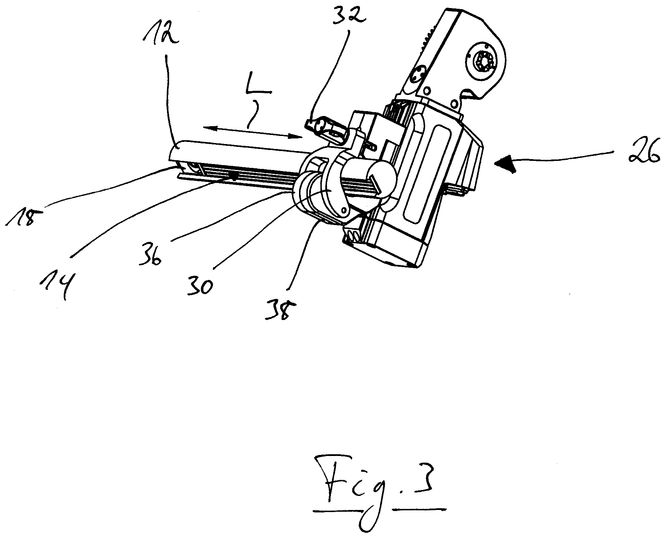

Fig. 3 zeigt die Anordnung von Fig. 2 in einer Perspektivansicht, wobei die Zubehörkomponente 26 an der Haltestange 12 montiert ist, d.h. die Haltestange 12 ist abschnittsweise umfänglich in der Schelle 28 aufgenommen, wobei der Schwenkarm 30 durch das Verriegelungselement 32 in einer Verriegelungsstellung gehalten wird, in der die Zubehörkomponente 26 durch Klemmsitz an der Haltestange 12 befestigt ist. Die Zubehörkomponente 26 ist derart an der Haltestange 12 montiert, dass der Stromabnehmer 34 in die Vertiefung 14 der Haltestange 12 eingreift und den in der Vertiefung 14 befindlichen Kontaktbereich 16 elektrisch kontaktiert. Die Zubehörkomponente 26 kann nun über den Kontaktbereich 16 elektrisch versorgt werden.

Wie ebenfalls in Fig. 3 erkennbar, ist der Schwenkarm 30 gabelförmig ausgebildet, wobei die Leitung 36 durch den Schwenkarm 30 hindurchgeführt ist. Der Schwenkarm 30 kann somit unabhängig von der Leitung 36 verschwenkt werden. Aufgrund der in Längsrichtung der Haltestange 12 durchgehenden Vertiefung 14 kann die Zubehörkomponente 26 wahlweise in einer beliebigen Position entlang der Längsachse L montiert und stets elektrisch versorgt werden.

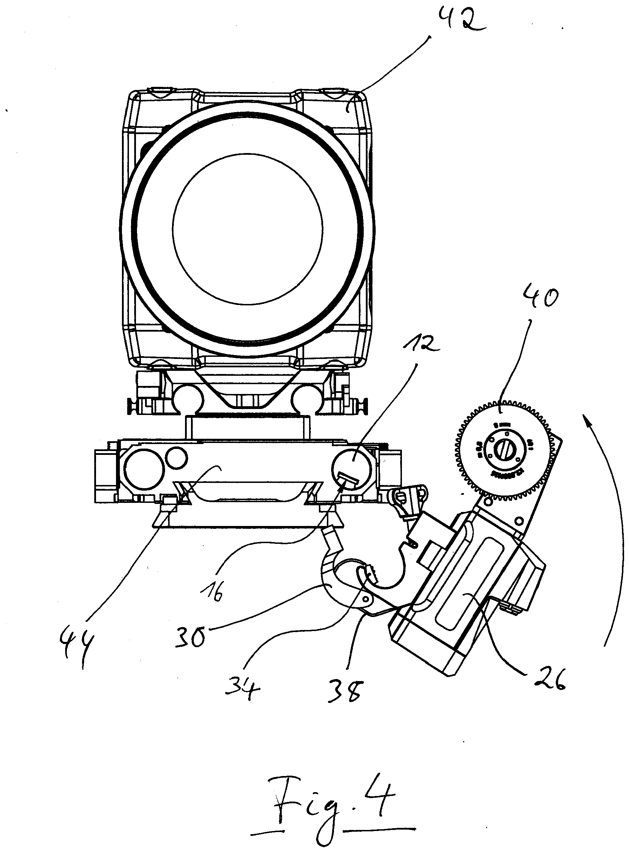

Fig. 4 zeigt analog zu der Anordnung von Fig. 2 die Haltestange 12 und eine Zubehörkomponente 26 in einer Frontansicht. Abweichend zu Fig. 2 ist die Haltestange 12 an einer Befestigungseinrichtung 44 montiert, die eine Filmkamera 42 trägt und als Befestigungsbrücke ausgebildet ist (sogenannte "bridge plate"). Die Befestigungseinrichtung 44 ist dazu ausgebildet, zwei Haltestangen 12 parallel zueinander zu halten. Die Befestigungseinrichtung 44 und die Haltestangen 12 können hierbei Teile eines Stützsystems der Filmkamera 42 sein.

Die Haltestange 12 ist derart an der Befestigungseinrichtung 44 montiert, dass die Vertiefung 14 mit dem Kontaktbereich 16 schräg nach unten weist. Hierdurch ist die Gefahr ungewollter Kontaktierungen des Kontaktbereichs 16 minimiert.

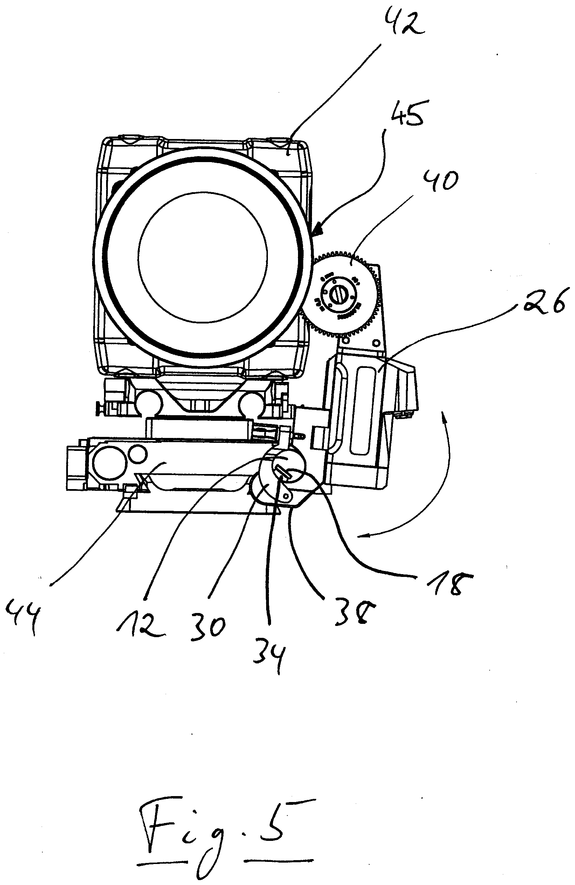

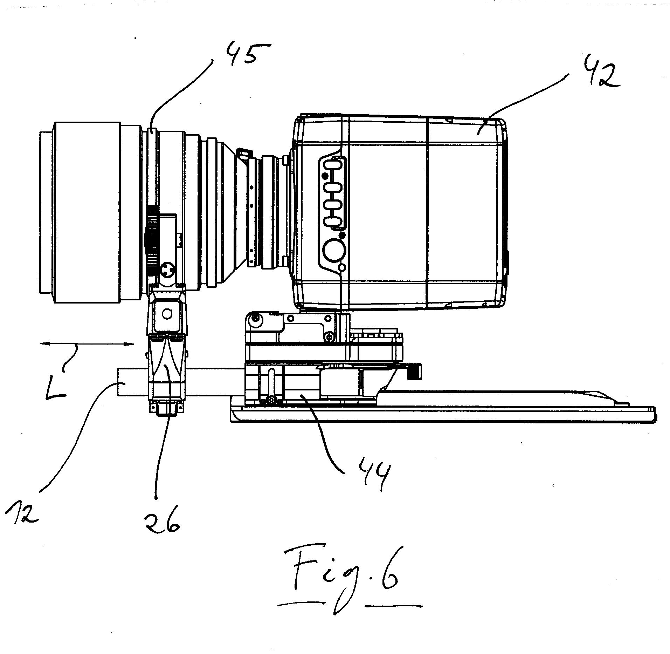

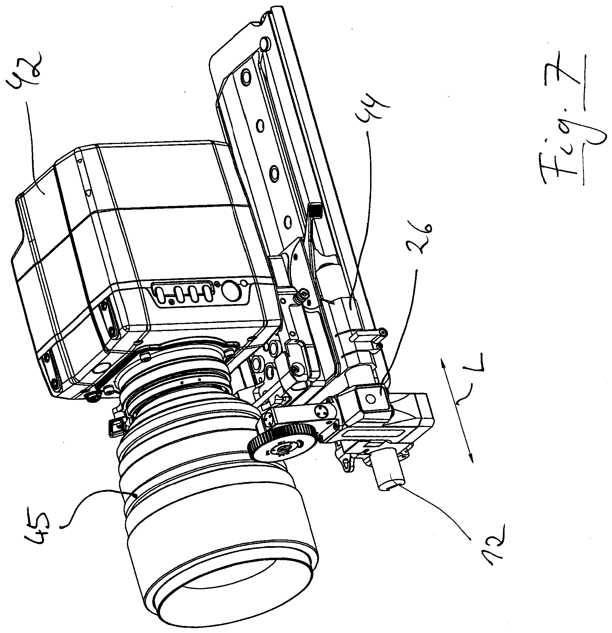

In Fig. 5 ist die Anordnung von Fig. 4 in einem Zustand dargestellt, in dem die Zubehörkomponente 26 nun analog zu Fig. 3 an der Haltestange 12 montiert ist. Im montierten Zustand ist die Zubehörkomponente 26 über das Antriebsrad 40 drehwirksam mit einem Verstellring 45 eines Objektivs der Filmkamera 42 gekoppelt (in Fig. 5 verdeckt; vgl. jedoch die Seitenansicht bzw. Perspektivansicht gemäß Fig. 6 und 7). Die Zubehörkomponente 26 kann über den Kontaktbereich 16 mit elektrischer Energie und/oder mit Signaldaten versorgt werden, sodass die Zubehörkomponente 26 den Verstellring 45 automatisch in eine gewünschte Position drehen kann.

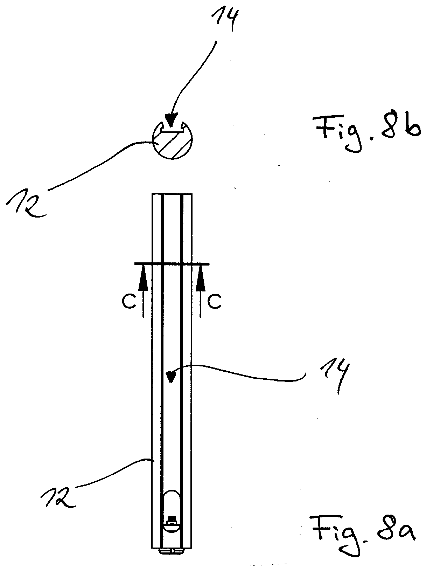

In Fig. 8 bis 12 sind beispielhafte Ausführungsformen der Haltestange 12 gezeigt, wobei die jeweilige Kontaktplatine 18, die in den Ausführungsformen gemäß Fig. 8 bis 12 in der Vertiefung 14 anzuordnen ist, in den Fig. 8 bis 12 nicht gezeigt ist. Eine separate und/oder lösbare Kontaktplatine 18 muss jedoch nicht unbedingt vorgesehen sein. Der Kontaktbereich 16 kann grundsätzlich auch integral an der Haltestange 12 ausgebildet sein.

In Fig. 8a ist die Haltestange 12 in einer Draufsicht bezüglich der Vertiefung 14 gezeigt. Fig. 8b zeigt eine Querschnittansicht der Haltestange 12 entlang der in Fig. 8a eingetragenen Schnittebene C - C. Wie sich aus Fig. 8b ergibt, handelt es sich bei der Haltestange 12 um eine im Wesentlichen massive Stange.

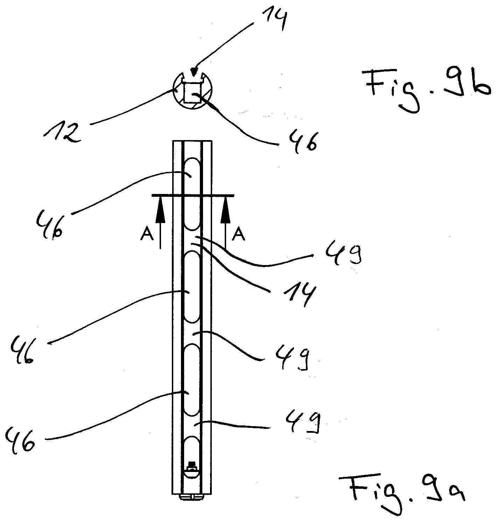

Die in Fig. 9a (Draufsicht) und Fig. 9b (Querschnittansicht entlang der Schnittebene A - A von Fig. 9a) gezeigte Haltestange 12 weicht von der in Fig. 8 gezeigten Haltestange 12 dadurch ab, dass im Bereich der Vertiefung 14 mehrere in Längsrichtung verteilte Ausnehmungen 46 vorgesehen sind, die z.B. durch Fräsen auf einfache Weise hergestellt werden können. Hierdurch kann das Gewicht der Haltestange 12 reduziert werden, wobei die Stabilität der Haltestange 12 durch zwischen zwei benachbarten Ausnehmungen 46 verbleibende Stege 49 kaum oder lediglich geringfügig reduziert ist.

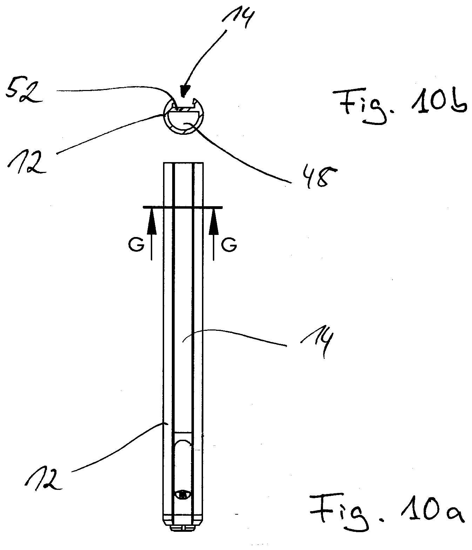

Die Haltestange 12 von Fig. 10a (Draufsicht) und Fig. 10b (Querschnittansicht entlang der Schnittebene G - G von Fig. 10a) zeichnet sich durch einen in Längsrichtung im Wesentlichen durchgehenden Hohlraum 48 auf, der z.B. durch ein Extrusionsverfahren hergestellt werden kann und das Gewicht der Haltestange 12 gegenüber der Ausführungsform von Fig. 9 noch weiter reduziert. Zwischen der Vertiefung 14 und dem Hohlraum 48 ist ein integraler Boden 52 vorgesehen, durch den insbesondere die mechanische Stabilität der Haltestange 12 im Wesentlichen erhalten bleibt.

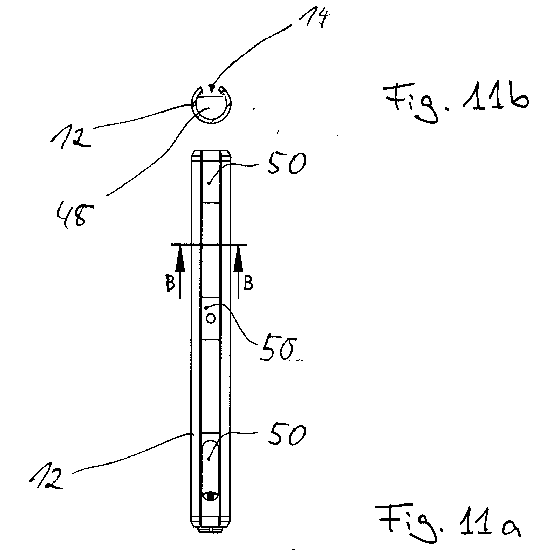

Die Haltestange 12 von Fig. 11a (Draufsicht) und Fig. 11b (Querschnittansicht entlang der Schnittebene B - B von Fig. 11a) ist ein geschlitztes (Hohl-)Rohr. Die mechanische Stabilität der Haltestange 12 kann in diesem Fall durch z.B. aus Kunststoff gebildete Einsätze 50 gewährleistet werden, die in regelmäßigen Abständen entlang der Längsachse L in den im Wesentlichen durchgehenden Hohlraum 48 der Haltestange 12 eingesetzt sind. Ferner dienen die Einsätze 50 als Stützauflagen für die Kontaktplatine 18 (in Fig. 11a und 11b nicht gezeigt).

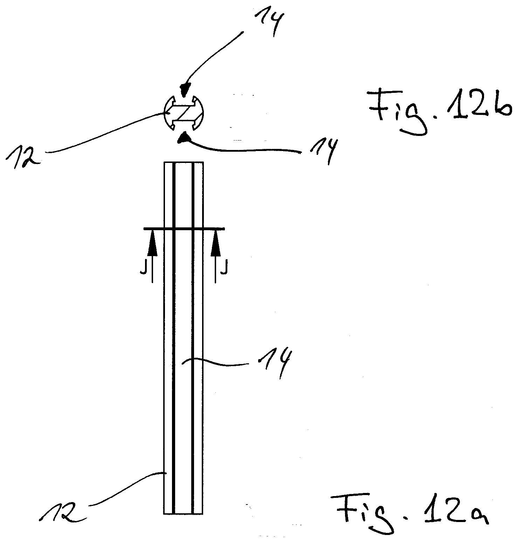

Die Haltestange 12 von Fig. 12a (Draufsicht) und Fig. 12b (Querschnittansicht entlang der Schnittebene J - J von Fig. 12a) entspricht der Haltestange 12 von Fig. 8, wobei zusätzlich eine weitere Vertiefung 14 vorgesehen ist. Die beiden Vertiefungen 14 sind diametral gegenüberliegend angeordnet und dienen jeweils zur Aufnahme einer Kontaktplatine 18. Alternativ können die jeweiligen Kontaktbereiche 16 in der jeweiligen Vertiefung 14 auch integral mit der Haltestange 12 ausgebildet sein. Insbesondere können in den beiden Vertiefungen 14 Kontaktbereiche 16 unterschiedlicher Polarität vorgesehen sein.

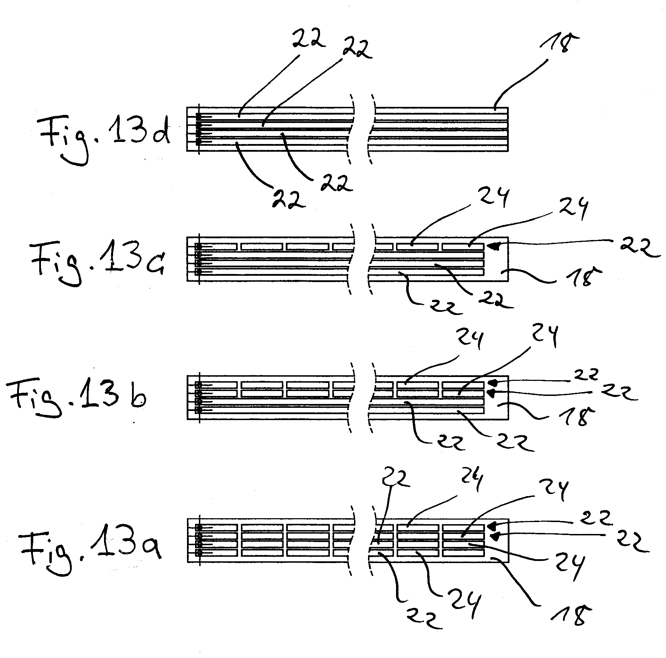

In Fig. 13 sind vier beispielhafte Ausgestaltungen für den Kontaktbereich 16 der Kontaktplatine 18 gezeigt. In Fig. 13a sind vier in Längsrichtung parallele Kontaktbahnen 22 jeweils mit identischer Rasterung in Längsrichtung in Kontaktsektionen 24 unterteilt. Dies entspricht dem Fall der Kontaktplatine von Fig. 1. In Fig. 13b sind zwei Kontaktbahnen 22 durchgehend, d.h. nicht unterteilt ausgebildet. Zwei weitere Kontaktbahnen 22 sind regelmäßig in Kontaktsektionen 24 unterteilt. Bei dem Kontaktbereich 16 von Fig. 13c sind abweichend von demjenigen von Fig. 13b drei der vier Kontaktbahnen 22 durchgehend ausgebildet. In Fig. 13d sind sämtlichen Kontaktbahnen 22 durchgehend. Die Kontaktbereiche 16 von Fig. 13a bis 13b müssen nicht an der Kontaktplatine 18 ausgebildet sein. Sie können auch unmittelbar an der Haltestange 12, insbesondere integral in der Vertiefung, ausgebildet sein.

Mittels einer nicht gezeigten Sensorik kann die Position einer an der Haltestange 12 montierten Zubehörkomponente 26 erfasst werden, um mithilfe einer nicht gezeigten jeweiligen Schalteinrichtung zumindest eine Kontaktbahn 22 bzw. eine Kontaktsektion 24 freizuschalten, die den Stromabnehmer 34 der Zubehörkomponente 26 elektrisch kontaktiert. Auf diese Weise kann die elektrische Anbindung der Zubehörkomponente 26 vollautomatisch und besonders sicher erfolgen, wobei das Risiko eines elektrischen Kurzschlusses auf ein Minimum reduziert wird. Eine umständliche Anbindung der Zubehörkomponente über Kabel ist nicht mehr erforderlich.

Hierfür kann die jeweilige Kontaktsektion 24 einer jeweiligen Kontaktbahn 22 beispielsweise (über jeweilige Durchkontaktierungen der Kontaktplatine 18) wahlweise elektrisch aktiv geschaltet werden, wobei an der Unterseite des Kontaktbereichs 16 die genannten Schalteinrichtungen sowie entsprechende Steuerleitungen und eine oder mehrere Versorgungsleitung(en) für eine Konstantpotential-Versorgung und/oder für eine Signalübertragung vorgesehen sein können (in der Draufsicht gemäß Fig. 13a bis 13b nicht ersichtlich). Die genannte Sensorik kann mehrere Sensoren umfassen (z.B. Reed-Schalter), die ebenfalls an dem Kontaktbereich 16 bzw. an der Kontaktplatine 18 angeordnet sein können, wobei für eine jeweilige Anzahl von Kontaktsektionen 24 in Längsrichtung des Kontaktbereichs 16 (z.B. eine, zwei, drei oder vier Kontaktsektionen 24) ein jeweiliger Sensor vorgesehen sein kann. An dem Kontaktbereich 16 oder an einem anderen Abschnitt der Haltestange 12 kann auch eine zugeordnete Steuerschaltung (nicht gezeigt) zum Ansteuern der genannten Schalteinrichtungen vorgesehen sein, beispielsweise in einen Zentralabschnitt oder an einem Längsende des Kontaktbereichs 16, an der Oberseite oder an der Unterseite.

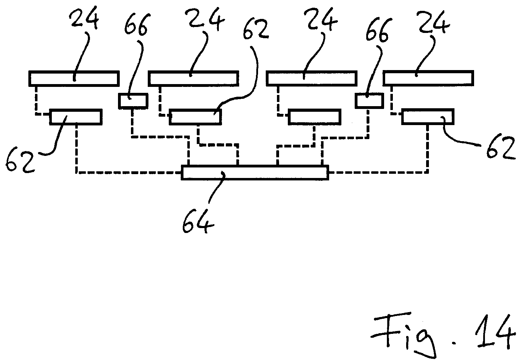

Fig. 14 illustriert eine mögliche Verschaltung einer derartigen Anordnung in einem Blockschaltbild. Gezeigt sind vier in Längsrichtung hintereinander angeordnete Kontaktsektionen 24, wobei parallel hierzu weitere Kontaktsektionen 24 oder Kontaktbahnen 22 vorgesehen sein können. Jede Kontaktsektion 24 ist mit einer jeweiligen Schalteinrichtung 62 verbunden, wobei die Schalteinrichtungen 62 von einer gemeinsamen Steuerschaltung 64 angesteuert werden. Zwischen jeweils zwei benachbarten Kontaktsektionen 24 ist ein Sensor 66 angeordnet. Sobald einer der Sensoren 66 die Anwesenheit einer Zubehörkomponente 26 (vgl. Fig. 2 bis 7) detektiert, übermittelt der Sensor 66 ein entsprechendes Meldesignal an die Steuerschaltung 64. Die Steuerschaltung 64 schaltet in Ansprechen auf ein solches Meldesignal über die jeweiligen Schalteinrichtungen 62 die zwei zu dem Sensor 66 benachbarten Kontaktsektionen 24 elektrisch aktiv, um über diese Kontaktsektionen 24 eine Energieversorgung der Zubehörkomponente 26 und/oder eine Signalübertragung von und/oder zu der Zubehörkomponente 26 zu ermöglichen.

### Bezugszeichenliste

- 12: Haltestange
- 14: Vertiefung
- 16: Kontaktbereich
- 18: Kontaktplatine
- 19: Seitenfläche
- 20: Anschlussfortsatz
- 22: Kontaktbahn
- 24: Kontaktsektion
- 26: Zubehörkomponente
- 28: Schelle
- 30: Schwenkarm
- 32: Verriegelungselement
- 34: Stromabnehmer
- 35: Abschnitt
- 36: Leitung
- 38: Leitung
- 40: Antriebsrad
- 42: Filmkamera
- 44: Befestigungseinrichtung
- 45: Verstellring
- 46: Ausnehmung
- 48: Hohlraum
- 49: Steg
- 50: Einsatz
- 52: Boden
- 56: Hinterschneidung
- 58: Nut
- 62: Schalteinrichtung
- 64: Steuerschaltung
- 66: Sensor

- L: Längsachse

## Patentansprüche

1. Stützsystem umfassend wenigstens zwei Haltestangen (12) und eine Befestigungseinrichtung (44), die zum Befestigen der zwei Haltestangen (12) an einer Filmkamera (42) in einer Befestigungsposition ausgebildet ist, wobei wenigstens eine der zwei Haltestangen (12) zum Halten einer Zubehörkomponente (26) relativ zu der Filmkamera (42) in einer variablen Position entlang einer Längsachse (L) der Haltestange (12) ausgebildet ist,
wobei die zum Halten der Zubehörkomponente (26) ausgebildete Haltestange (12) wenigstens eine nach außen geöffnete Vertiefung (14) aufweist, und wobei die Haltestange (12) in der Vertiefung (14) einen zurückversetzten, von außen zugänglichen Kontaktbereich (16) zur elektrischen Kontaktierung der Zubehörkomponente (26) aufweist.

2. Stützsystem umfassend eine Haltestange (12) und einen Käfig zum Befestigen der Haltestange (12) an einer Filmkamera (42), wobei der Käfig dazu ausgebildet ist, die Filmkamera (42) zu umgeben, wobei die Haltestange (12) zum Halten einer Zubehörkomponente (26) relativ zu der Filmkamera (42) in einer variablen Position entlang einer Längsachse (L) der Haltestange (12) ausgebildet ist,
wobei die Haltestange (12) wenigstens eine nach außen geöffnete Vertiefung (14) aufweist, und wobei die Haltestange (12) in der Vertiefung (14) einen zurückversetzten, von außen zugänglichen Kontaktbereich (16) zur elektrischen Kontaktierung der Zubehörkomponente (26) aufweist.

3. Stützsystem nach Anspruch 1 oder 2,
wobei die zum Halten der Zubehörkomponente (26) ausgebildete Haltestange (12) durch eine massive Stange, durch ein hohles Rohr oder durch ein Rohr mit Innenstruktur gebildet ist, an der/dem die Vertiefung (14) ausgebildet ist; und/oder
wobei die zum Halten der Zubehörkomponente (26) ausgebildete Haltestange (12) einen zumindest im Wesentlichen kreisförmigen Querschnitt aufweist, der entlang der Längsachse (L) zumindest abschnittsweise konstant ist; und/oder
wobei die Vertiefung (14) länglich ausgebildet ist und sich entlang der Längsachse (L) der Haltestange (12) erstreckt; und/oder wobei die Vertiefung (14) durch eine im Wesentlichen T-förmige Nut gebildet ist; und/oder
wobei die zum Halten der Zubehörkomponente (26) ausgebildete Haltestange (12) unterhalb eines Bodens (52) der Vertiefung (14) zumindest abschnittsweise hohl ist.

4. Stützsystem nach zumindest einem der vorhergehenden Ansprüche, wobei die zum Halten der Zubehörkomponente (26) ausgebildete Haltestange (12) an verschiedenen Umfangsabschnitten zwei nach außen geöffnete Vertiefungen (14) aufweist, und wobei die Haltestange (12) in jeder der zwei Vertiefungen (14) einen zurückversetzten, von außen zugänglichen Kontaktbereich (16) zur elektrischen Kontaktierung der Zubehörkomponente (16) aufweist.

5. Stützsystem nach zumindest einem der vorhergehenden Ansprüche, wobei in der Vertiefung (14) bzw. in jeder der zwei Vertiefungen (14) wenigstens eine Kontaktplatine (18) angeordnet ist, an der der Kontaktbereich (16) ausgebildet ist.

6. Stützsystem nach Anspruch 5,
wobei die Vertiefung (14) entlang der Längsachse (L) der Haltestange (12) zumindest abschnittsweise wenigstens eine Hinterschneidung (56) aufweist, wobei die Kontaktplatine (18) zwischen einem Boden (52) der Vertiefung und der Hinterschneidung (56) gefangen ist; und/oder
wobei die Vertiefung (14) entlang der Längsachse (L) der Haltestange (12) durch Seitenflächen (19) begrenzt ist, die relativ zu der Erstreckungsebene der Kontaktplatine (18) geneigt sind und nach außen weisen.

7. Stützsystem nach zumindest einem der vorhergehenden Ansprüche,
wobei der Kontaktbereich (16) mehrere zueinander benachbarte, sich entlang der Längsachse (L) der Haltestange (12) erstreckende Kontaktbahnen (22) umfasst, die elektrisch voneinander isoliert sind.

8. Stützsystem nach zumindest einem der vorhergehenden Ansprüche,
wobei der Kontaktbereich (16) entlang der Längsachse (L) der Haltestange (12) in mehrere Kontaktsektionen (24) unterteilt ist, die elektrisch voneinander isoliert sind;
wobei die zum Halten der Zubehörkomponente (26) ausgebildete Haltestange (12) insbesondere wenigstens eine elektrische Busleitung aufweist, die sich entlang der mehreren Kontaktsektionen (24) durchgehend erstreckt, um die mehreren Kontaktsektionen (24) mit elektrischer Energie zu versorgen und/oder um elektrische Signale von und zu den mehreren Kontaktsektionen (24) zu übertragen.

9. Stützsystem nach zumindest einem der Ansprüche 1 bis 7,
wobei die zum Halten der Zubehörkomponente (26) ausgebildete Haltestange (12) eine Sensorik zur Erfassung der Anwesenheit und/oder der Position und/oder eines Identifikationsmerkmals der von der Haltestange (12) gehaltenen Zubehörkomponente (26) umfasst.

10. Stützsystem nach Anspruch 9,
wobei die Sensorik wenigstens einen Sensor (66) aufweist, der
- einen Hall-Sensor,
- einen Reed-Schalter,
- einen elektrischen Kontaktschalter,
- einen mechanischen Kontaktschalter, und/oder
- einen Funkfrequenzempfänger
umfasst; und/oder
wobei der Kontaktbereich (16) entlang der Längsachse (L) der Haltestange (12) in mehrere elektrisch voneinander isolierte Kontaktsektionen (24) unterteilt ist, und wobei die zum Halten der Zubehörkomponente (26) ausgebildete Haltestange (12) wenigstens eine Steuerschaltung (64) aufweist, die dazu konfiguriert ist, in Abhängigkeit von der erfassten Anwesenheit und/oder Position und/oder dem erfassten Identifikationsmerkmal der von der Haltestange (12) gehaltenen Zubehörkomponente (26) wenigstens eine der mehreren Kontaktsektionen (24) für eine elektrische Energieversorgung der Zubehörkomponente (26) und/oder für eine elektrische Signalübertragung von oder zu der Zubehörkomponente (26) selektiv zu aktivieren, wobei die zum Halten der Zubehörkomponente (26) ausgebildete Haltestange (12) insbesondere wenigstens eine elektrische Busleitung aufweist, die sich entlang der mehreren Kontaktsektionen (24) durchgehend erstreckt, um die mehreren Kontaktsektionen (24) mit elektrischer Energie zu versorgen und/oder um elektrische Signale von und zu den mehreren Kontaktsektionen (24) zu übertragen.

11. Stützsystem nach zumindest einem der vorhergehenden Ansprüche,
wobei die zum Halten der Zubehörkomponente (26) ausgebildete Haltestange (12) wenigstens eine elektrische Schnittstelle (20) zum Verbinden des Kontaktbereichs (16) mit einer elektrischen Energiequelle und/oder mit einer externen Kommunikationseinrichtung aufweist; und/oder
wobei die zum Halten der Zubehörkomponente (26) ausgebildete Haltestange (12) entlang ihrer Längsachse (L) mehrere Vertiefungen (14) aufweist, wobei die Haltestange (12) in jeder der mehreren Vertiefungen (14) einen jeweiligen Kontaktbereich (16) aufweist, wobei der jeweilige Kontaktbereich (16) eine Kontaktbahn (22) oder wenigstens zwei nebeneinander verlaufende Kontaktbahnen (22) umfasst.

12. Stützsystem nach zumindest einem der vorhergehenden Ansprüche,
wobei der Kontaktbereich (16) eine Kontaktbahn (22) umfasst, die sich entlang der Längsachse (L) der Haltestange (12) erstreckt, wobei die Kontaktbahn (22) einen ersten elektrischen Anschluss für eine elektrische Energieversorgung der Zubehörkomponente (26) und/oder für eine elektrische Signalübertragung von oder zu der Zubehörkomponente (26) bildet;
wobei die zum Halten der Zubehörkomponente (26) ausgebildete Haltestange (12) insbesondere elektrisch leitend ist und einen zweiten elektrischen Anschluss für die elektrische Energieversorgung der Zubehörkomponente (26) und/oder für die elektrische Signalübertragung von oder zu der Zubehörkomponente (26) bildet; und/oder
wobei die Kontaktbahn (22) entlang der Längsachse (L) der Haltestange (12) insbesondere in mehrere elektrisch voneinander isolierte Kontaktsektionen (24) unterteilt ist.

13. Stützsystem nach zumindest einem der Ansprüche 1 bis 11,
wobei der Kontaktbereich (16) wenigstens eine erste Kontaktbahn (22) und eine zweite Kontaktbahn (22) umfasst, die sich entlang der Längsachse (L) der Haltestange (12) erstrecken, wobei die zweite Kontaktbahn (22) neben der ersten Kontaktbahn (22) verläuft, wobei die erste Kontaktbahn (22) einen ersten elektrischen Anschluss und die zweite Kontaktbahn (22) einen zweiten elektrischen Anschluss für eine elektrische Energieversorgung der Zubehörkomponente (26) und/oder für eine elektrische Signalübertragung von oder zu der Zubehörkomponente (26) bilden;
wobei die erste Kontaktbahn (22) und/oder die zweite Kontaktbahn (22) entlang der Längsachse (L) der Haltestange (12) insbesondere in mehrere elektrisch voneinander isolierte Kontaktsektionen (24) unterteilt ist/sind.

14. Stützsystem nach zumindest einem der Ansprüche 1 bis 11,
wobei die zum Halten der Zubehörkomponente (26) ausgebildete Haltestange (12) an einem ersten Umfangsabschnitt eine erste Vertiefung (14) mit einem ersten Kontaktbereich (16) und an einem zweiten Umfangsabschnitt eine zweite Vertiefung (14) mit einem zweiten Kontaktbereich (16) aufweist, wobei der erste Kontaktbereich (16) einen ersten elektrischen Anschluss und der zweite Kontaktbereich (16) einen zweiten elektrischen Anschluss für eine elektrische Energieversorgung der Zubehörkomponente (26) und/oder für eine elektrische Signalübertragung von oder zu der Zubehörkomponente (26) bilden;
wobei der erste Kontaktbereich (16) und/oder der zweite Kontaktbereich (16) entlang der Längsachse (L) der Haltestange (12) insbesondere in mehrere elektrisch voneinander isolierte Kontaktsektionen (24) unterteilt ist/sind.

15. Stützsystem nach Anspruch 1,
wobei eine erste und eine zweite der wenigstens zwei Haltestangen (12) wenigstens eine nach außen geöffnete Vertiefung (14) und in der Vertiefung (14) einen zurückversetzten, von außen zugänglichen Kontaktbereich (16) zur elektrischen Kontaktierung der Zubehörkomponente (26) aufweisen, wobei der Kontaktbereich (16) der ersten Haltestange (12) eine Kontaktbahn (22) umfasst, die sich entlang der Längsachse (L) der ersten Haltestange (12) erstreckt, wobei die Kontaktbahn (22) einen ersten elektrischen Anschluss für eine elektrische Energieversorgung der Zubehörkomponente (26) und/oder für eine elektrische Signalübertragung von oder zu der Zubehörkomponente (26) bildet, und
wobei der Kontaktbereich (16) der zweiten Haltestange (12) eine Kontaktbahn (22) umfasst, die sich entlang der Längsachse (L) der zweiten Haltestange (12) erstreckt und die einen zweiten elektrischen Anschluss für die elektrische Energieversorgung der Zubehörkomponente (26) und/oder für die elektrische Signalübertragung von oder zu der Zubehörkomponente (26) bildet.

16. Verwendung einer Haltestange (12),
die wenigstens eine nach außen geöffnete Vertiefung (14) aufweist, wobei die Haltestange (12) in der Vertiefung (14) einen zurückversetzten, von au-ßen zugänglichen Kontaktbereich (16) zur elektrischen Kontaktierung einer Zubehörkomponente (26) für eine Filmkamera (42) aufweist,
zum Halten der Zubehörkomponente (26) für eine Filmkamera (42), nämlich eines Stellmotors für einen Objektivring oder für eine Filtereinheit, eines Funkmoduls für eine drahtlose Datenübertragung, oder eines Monitors zum Anzeigen von Daten, relativ zu der Filmkamera (42) in einer variablen Position entlang einer Längsachse (L) der Haltestange (12), wobei die Zubehörkomponente (26) an der Haltestange (12) befestigt wird.

17. Zubehörkomponente (26) für eine Filmkamera (42), mit einer Befestigungseinrichtung (44), die dazu konfiguriert ist, die Zubehörkomponente (26) in einer variablen Position relativ zu der Filmkamera (42) entlang einer Längsachse (L) einer Haltestange (12) zu befestigen, und mit einem elektrischen Stromabnehmer (34), der dazu konfiguriert ist, in eine Vertiefung (14) der Haltestange (12) einzugreifen, um einen in der Vertiefung (14) befindlichen Kontaktbereich (16) elektrisch zu kontaktieren,
wobei die Zubehörkomponente (26) ein Stellmotor für einen Objektivring oder für eine Filtereinheit, oder ein Funkmodul für eine drahtlose Datenübertragung, oder ein Monitor zum Anzeigen von Daten ist.

## Claims

1. A support system comprising at least two support rods (12) and a fastening device (44) which is configured to fasten the two support rods (12) to a motion picture camera (42) in a fastening position, wherein at least one of the two support rods (12) is configured to hold an accessory component (26) relative to the motion picture camera (42) in a variable position along a longitudinal axis (L) of the support rod (12),
wherein the support rod (12) configured for holding the accessory component (26) has at least one outwardly open recess (14); and wherein the support rod (12) has a set back contact region (16) in the recess (14) that is accessible from the outside for the electrical contacting of the accessory component (26).

2. A support system comprising a support rod (12) and a cage for fastening the support rod (12) to a motion picture camera (42), wherein the cage is configured to surround the motion picture camera (42), wherein the support rod (12) is configured to hold an accessory component (26) relative to the motion picture camera (42) in a variable position along a longitudinal axis (L) of the support rod (12),
wherein the support rod (12) has at least one outwardly open recess (14), and wherein the support rod (12) has a set back contact region (16) in the recess (14) that is accessible from the outside for the electrical contacting of the accessory component (26).

3. A support system in accordance with claim 1 or claim 2,
wherein the support rod (12) configured for holding the accessory component (26) is formed by a solid rod, by a hollow tube or by a tube having an internal structure at which the recess (14) is formed; and/or
wherein the support rod (12) configured for holding the accessory component (26) has an at least substantially circular cross-section which is at least sectionally constant along the longitudinal axis (L); and/or wherein the recess (14) is elongate and extends along the longitudinal axis (L) of the support rod (12); and/or
wherein the recess (14) is formed by a substantially T-shaped groove; and/or
wherein the support rod (12) configured for holding the accessory component (26) is at least sectionally hollow beneath a base (52) of the recess (14).

4. A support system in accordance with at least one of the preceding claims, wherein the support rod (12) configured for holding the accessory component (26) has two outwardly open recesses (14) at different peripheral sections; and wherein the support rod (12) has a set back contact region (16) in each of the two recesses (14) that is accessible from the outside for the electrical contacting of the accessory component (26).

5. A support system in accordance with at least one of the preceding claims, wherein at least one contact board (18) at which the contact region (18) is formed is arranged in the recess (14) or in each of the two recesses (14).

6. A support system in accordance with claim 5,
wherein the recess (14) has at least one undercut (56) at least sectionally along the longitudinal axis (L) of the support rod (12), with the contact board (18) being captured between a base (52) of the recess and the undercut (56); and/or
wherein the recess (14) is bounded along the longitudinal axis (L) of the support rod (12) by side surfaces (19) which are inclined relative to the plane of extent of the contact board (18) and which face outwardly.

7. A support system in accordance with at least one of the preceding claims, wherein the contact region (16) comprises a plurality of mutually adjacent contact tracks (22) which extend along the longitudinal axis (L) of the support rod (12) and which are electrically insulated from one another.

8. A support system in accordance with at least one of the preceding claims, wherein the contact region (16) is divided along the longitudinal axis (L) of the support rod (12) into a plurality of contact sections (24) which are electrically insulated from one another;
wherein the support rod (12) configured for holding the accessory component (26) in particular has at least one electrical bus line which extends continuously along the plurality of contact sections (24) to supply the plurality of contact sections (24) with electrical energy and/or to transmit electrical signals from and to the plurality of contact sections (24).

9. A support system in accordance with at least one of the claims 1 to 7,
wherein the support rod (12) configured for holding the accessory component (26) comprises a sensor system for detecting the presence and/or the position and/or an identification feature of the accessory component (26) held by the support rod (12).

10. A support system in accordance with claim 9,
wherein the sensor system has at least one sensor (66) which comprises
- a Hall sensor;
- a reed switch;
- an electric contact switch;
- a mechanical contact switch; and/or
- a radio frequency receiver; and/or
wherein the contact region (16) is divided along the longitudinal axis (L) of the support rod (12) into a plurality of contact sections (24) which are electrically insulated from one another; and wherein the support rod (12) configured for holding the accessory component (26) has at least one control circuit (64) which is configured to selectively activate at least one of the plurality of contact sections (24) for an electrical energy supply of the accessory component (26) and/or for an electrical signal transmission from or to the accessory component (26) in dependence on the detected presence and/or position and/or on the detected identification feature of the accessory component (26) held by the support rod (12), wherein the support rod (12) configured for holding the accessory component (26) in particular has at least one electrical bus line which extends continuously along the plurality of contact sections (24) to supply the plurality of contact sections (24) with electrical energy and/or to transmit electrical signals from and to the plurality of contact sections (24).

11. A support system in accordance with at least one of the preceding claims, wherein the support rod (12) configured for holding the accessory component (26) has at least one electrical interface (20) for connecting the contact region (16) to an electrical energy source and/or to an external communication device; and/or
wherein the support rod (12) configured for holding the accessory component (26) has a plurality of recesses (14) along its longitudinal axis (L), with the support rod (12) having a respective contact region (16) in each of the plurality of recesses (14), and with the respective contact region (16) comprising a contact track (22) or at least two contact tracks (22) extending next to one another.

12. A support system in accordance with at least one of the preceding claims, wherein the contact region (16) comprises a contact track (22) which extends along the longitudinal axis (L) of the support rod (12), with the contact track (22) forming a first electrical terminal for an electrical energy supply of the accessory component (26) and/or for an electrical signal transmission from or to the accessory component (26);
wherein the support rod (12) configured for holding the accessory component (26) is in particular electrically conductive and forms a second electrical terminal for the electrical energy supply of the accessory component (26) and/or for the electrical signal transmission from or to the accessory component (26); and/or
wherein the contact track (22) is in particular divided into a plurality of electrically mutually insulated contact sections (24) along the longitudinal axis (L) of the support rod (12).

13. A support system in accordance with at least one of the claims 1 to 11,
wherein the contact region (16) comprises at least a first contact track (22) and a second contact track (22) which extend along the longitudinal axis (L) of the support rod (12), with the second contact track (22) extending next to the first contact track (22) and with the first contact track (22) forming a first electrical terminal and the second contact track (22) forming a second electrical terminal for an electrical energy supply of the accessory component (26) and/or for an electrical signal transmission from or to the accessory component (26);
wherein the first contact track (22) and/or the second contact track (22) is/are in particular divided into a plurality of electrically mutually insulated contact sections (24) along the longitudinal axis (L) of the support rod (12).

14. A support system in accordance with at least one of the claims 1 to 11,
wherein the support rod (12) configured for holding the accessory component (26) has a first recess (14) having a first contact region (16) at a first peripheral section and a second recess (14) having a second contact region (16) at a second peripheral section, with the first contact region (16) forming a first electrical terminal and the second contact region (16) forming a second electrical terminal for an electrical energy supply of the accessory component (26) and/or for an electrical signal transmission from or to the accessory component (26);
wherein the first contact region (16) and/or the second contact region (16) is/are in particular divided into a plurality of electrically mutually insulated contact sections (24) along the longitudinal axis (L) of the support rod (12).

15. A support system in accordance with claim 1,
wherein a first and a second one of the at least two support rods (12) have at least one outwardly open recess (14) and a set back contact region (16) in the recess (14) that is accessible from the outside for the electrical contacting of the accessory component (26);
wherein the contact region (16) of the first support rod (12) comprises a contact track (22) which extends along the longitudinal axis (L) of the first support rod (12), wherein the contact track (22) forms a first electrical terminal for an electrical energy supply of the accessory component (26) and/or for an electrical signal transmission from or to the accessory component (26); and
wherein the contact region (16) of the second support rod (12) comprises a contact track (22) which extends along the longitudinal axis (L) of the second support rod (12) and which forms a second electrical terminal for an electrical energy supply of the accessory component (26) and/or for the electrical signal transmission from or to the accessory component (26).

16. Use of a support rod (12),
which has at least one outwardly open recess (14), wherein the support rod (12) has a set back contact region (16) in the recess (14) that is accessible from the outside for the electrical contacting of an accessory component (26) for a motion picture camera (42),
for holding the accessory component (26) for a motion picture camera (42), namely a setting motor for an objective ring or for a filter unit, a radio module for a wireless data transmission, or a monitor for displaying data, relative to the motion picture camera (42) in a variable position along a longitudinal axis (L) of the support rod (12), wherein the accessory component (26) is fastened to the support rod (12).

17. An accessory component (26) for a motion picture camera (42) having a fastening device (44) which is configured to fasten the accessory component (26) in a variable position relative to the motion picture camera (42) along a longitudinal axis (L) of a support rod (12), and having an electrical current collector (34) which is configured to engage into a recess (14) of the support rod (12) to electrically contact a contact region (16) located in the recess (14),
wherein the accessory component (26) has a setting motor for an objective ring or for a filter unit, or a radio module for a wireless data transmission, or a monitor for displaying data. data.

## Revendications

1. Système de support comportant au moins deux barres de retenue (12) et un dispositif de fixation (44) réalisé pour fixer les deux barres de retenue (12) à une caméra cinématographique (42) dans une position de fixation, l'une au moins des deux barres de retenue (12) étant réalisée pour retenir un composant accessoire (26) par rapport à la caméra (42) dans une position variable le long d'un axe longitudinal (L) de la barre de retenue (12),
la barre de retenue (12) réalisée pour retenir le composant accessoire (26) présentant au moins un renfoncement (14) ouvert vers l'extérieur, et la barre de retenue (12) présentant dans le renfoncement (14) une zone de contact (16) en retrait, accessible de l'extérieur, pour la mise en contact électrique du composant accessoire (26).

2. Système de support comportant au moins une barre de retenue (12) et une cage destinée à fixer la barre de retenue (12) à une caméra cinématographique (42), la cage étant réalisée pour entourer la caméra (42), la barre de retenue (12) étant réalisée pour retenir un composant accessoire (26) par rapport à la caméra (42) dans une position variable le long d'un axe longitudinal (L) de la barre de retenue (12),
la barre de retenue (12) présentant au moins un renfoncement (14) ouvert vers l'extérieur, et la barre de retenue (12) présentant dans le renfoncement (14) une zone de contact (16) en retrait, accessible de l'extérieur, pour la mise en contact électrique du composant accessoire (26).

3. Système de support selon la revendication 1 ou 2,
dans lequel
la barre de retenue (12) réalisée pour retenir le composant accessoire (26) est formée par une barre massive, par un tube creux ou par un tube à structure interne sur laquelle/lequel est formé le renfoncement (14) ; et/ou
la barre de retenue (12) réalisée pour retenir le composant accessoire (26) présente une section transversale au moins sensiblement circulaire, qui est constante au moins localement le long de l'axe longitudinal (L) ; et/ou le renfoncement (14) est de forme allongée et s'étend le long de l'axe longitudinal (L) de la barre de retenue (12) ; et/ou
le renfoncement (14) est formé par une rainure sensiblement en forme de T ; et/ou
la barre de retenue (12) réalisée pour retenir le composant accessoire (26) est creuse au moins localement en dessous d'un fond (52) du renfoncement (14).

4. Système de support selon l'une au moins des revendications précédentes, dans lequel la barre de retenue (12) réalisée pour retenir le composant accessoire (26) présente, sur différentes parties périphériques, deux renfoncements (14) ouverts vers l'extérieur, et
la barre de retenue (12) présente, dans chacun des deux renfoncements (14), une zone de contact (16) en retrait, accessible de l'extérieur, pour la mise en contact électrique du composant accessoire (16).

5. Système de support selon l'une au moins des revendications précédentes, dans lequel au moins une platine de contact (18) est disposée dans le renfoncement (14) ou dans chacun des deux renfoncements (14), sur laquelle est formée la zone de contact (16).

6. Système de support selon la revendication 5,
dans lequel le renfoncement (14) présente au moins localement au moins une contre-dépouille (56) le long de l'axe longitudinal (L) de la barre de retenue (12), la platine de contact (18) étant emprisonnée entre un fond (52) du renfoncement et la contre-dépouille (56) ; et/ou
le renfoncement (14) est délimité le long de l'axe longitudinal (L) de la barre de retenue (12) par des surfaces latérales (19) qui sont inclinées par rapport au plan d'extension de la platine de contact (18) et qui sont dirigées vers l'extérieur.

7. Système de support selon l'une au moins des revendications précédentes, dans lequel la zone de contact (16) comprend plusieurs pistes de contact (22) adjacentes les unes aux autres et s'étendant le long de l'axe longitudinal (L) de la barre de retenue (12), lesquelles sont électriquement isolées les unes des autres.

8. Système de support selon l'une au moins des revendications précédentes, dans lequel la zone de contact (16) est subdivisée le long de l'axe longitudinal (L) de la barre de retenue (12) en plusieurs sections de contact (24) qui sont électriquement isolées les unes des autres ;
la barre de retenue (12) réalisée pour retenir le composant accessoire (26) comprend en particulier au moins une ligne de bus électrique s'étendant en continu le long desdites plusieurs sections de contact (24) pour alimenter en énergie électrique lesdites plusieurs sections de contact (24) et/ou pour transmettre des signaux électriques depuis et vers lesdites plusieurs sections de contact (24).

9. Système de support selon l'une au moins des revendications 1 à 7,
dans lequel la barre de retenue (12) réalisée pour retenir le composant accessoire (26) comprend un ensemble capteur pour détecter la présence et/ou la position et/ou une caractéristique d'identification du composant accessoire (26) retenu par la barre de retenue (12).

10. Système de support selon la revendication 9,
dans lequel l'ensemble capteur comprend au moins un capteur (66) qui est
- un capteur à effet Hall,
- un interrupteur à lames souples,
- un interrupteur de contact électrique,
- un interrupteur de contact mécanique, et/ou
- un récepteur de fréquence radio ;
et/ou
la zone de contact (16) est subdivisée le long de l'axe longitudinal (L) de la barre de retenue (12) en plusieurs sections de contact (24) électriquement isolées les unes des autres, et
la barre de retenue (12) réalisée pour retenir le composant accessoire (26) comprend au moins un circuit de commande (64) qui est configuré pour, en fonction de la présence et/ou de la position détectées et/ou de la caractéristique d'identification détectée du composant accessoire (26) retenu par la barre de retenue (12), activer sélectivement au moins l'une desdites plusieurs sections de contact (24) pour une alimentation en énergie électrique du composant accessoire (26) et/ou pour une transmission de signaux électrique depuis ou vers le composant accessoire (26),
la barre de retenue (12) réalisée pour retenir le composant accessoire (26) comprend en particulier au moins une ligne de bus électrique s'étendant en continu le long desdites plusieurs sections de contact (24) pour alimenter en énergie électrique lesdites plusieurs sections de contact (24) et/ou pour transmettre des signaux électriques depuis et vers lesdites plusieurs sections de contact (24).

11. Système de support selon l'une au moins des revendications précédentes, dans lequel la barre de retenue (12) réalisée pour retenir le composant accessoire (26) comprend au moins une interface électrique (20) pour relier la zone de contact (16) à une source d'énergie électrique et/ou à un dispositif de communication externe ; et/ou
la barre de retenue (12) réalisée pour retenir le composant accessoire (26) présente plusieurs renfoncements (14) le long de son axe longitudinal (L), la barre de retenue (12) présente une zone de contact respective (16) dans chacun desdits plusieurs renfoncements (14),
la zone de contact respective (16) comprend une piste de contact (22) ou au moins deux pistes de contact (22) s'étendant l'une à côté de l'autre.

12. Système de support selon l'une au moins des revendications précédentes, dans lequel la zone de contact (16) comprend une piste de contact (22) qui s'étend le long de l'axe longitudinal (L) de la barre de retenue (12), la piste de contact (22) constituant une première connexion électrique pour une alimentation en énergie électrique du composant accessoire (26) et/ou pour une transmission de signaux électrique depuis ou vers le composant accessoire (26) ;
la barre de retenue (12) réalisée pour retenir le composant accessoire (26) est en particulier électriquement conductrice et constitue une deuxième connexion électrique pour l'alimentation en énergie électrique du composant accessoire (26) et/ou pour la transmission de signaux électrique depuis ou vers le composant accessoire (26) ; et/ou
la piste de contact (22) est subdivisée le long de l'axe longitudinal (L) de la barre de retenue (12) en particulier en plusieurs sections de contact (24) électriquement isolées les unes des autres.

13. Système de support selon l'une au moins des revendications 1 à 11, dans lequel la zone de contact (16) comprend au moins une première piste de contact (22) et une deuxième piste de contact (22) qui s'étendent le long de l'axe longitudinal (L) de la barre de retenue (12), la deuxième piste de contact (22) s'étendant à côté de la première piste de contact (22), la première piste de contact (22) constituant une première connexion électrique et la deuxième piste de contact (22) constituant une deuxième connexion électrique pour une alimentation en énergie électrique du composant accessoire (26) et/ou pour une transmission de signaux électrique depuis ou vers le composant accessoire (26) ;
la première piste de contact (22) et/ou la deuxième piste de contact (22) sont subdivisée(s) le long de l'axe longitudinal (L) de la barre de retenue (12) en particulier en plusieurs sections de contact (24) électriquement isolées les unes des autres.

14. Système de support selon l'une au moins des revendications 1 à 11, dans lequel la barre de retenue (12) réalisée pour retenir le composant accessoire (26) présente, sur une première portion périphérique, un premier renfoncement (14) avec une première zone de contact (16) et, sur une deuxième portion périphérique, un deuxième renfoncement (14) avec une deuxième zone de contact (16), la première zone de contact (16) constituant une première connexion électrique et la deuxième zone de contact (16) constituant une deuxième connexion électrique pour une alimentation en énergie électrique du composant accessoire (26) et/ou pour une transmission de signaux électrique depuis ou vers le composant accessoire (26) ; la première zone de contact (16) et/ou la deuxième zone de contact (16) est/sont subdivisée(s) le long de l'axe longitudinal (L) de la barre de retenue (12) en particulier en plusieurs sections de contact (24) électriquement isolées les unes des autres.

15. Système de support selon la revendication 1,
dans lequel une première et une deuxième desdites au moins deux barres de retenue (12) présentent au moins un renfoncement (14) ouvert vers l'extérieur, et présentent dans le renfoncement (14) une zone de contact (16) en retrait, accessible de l'extérieur, pour la mise en contact électrique du composant accessoire (26),
la zone de contact (16) de la première barre de retenue (12) comprend une piste de contact (22) qui s'étend le long de l'axe longitudinal (L) de la première barre de retenue (12), la piste de contact (22) constituant une première connexion électrique pour une alimentation en énergie électrique du composant accessoire (26) et/ou pour une transmission de signaux électrique depuis ou vers le composant accessoire (26), et
la zone de contact (16) de la deuxième barre de retenue (12) comprend une piste de contact (22) qui s'étend le long de l'axe longitudinal (L) de la deuxième barre de retenue (12) et qui constitue une deuxième connexion électrique pour l'alimentation en énergie électrique du composant accessoire (26) et/ou pour la transmission de signaux électrique depuis ou vers le composant accessoire (26).

16. Utilisation d'une barre de retenue (12),
présentant au moins un renfoncement (14) ouvert vers l'extérieur, la barre de retenue (12) présentant dans le renfoncement (14) une zone de contact (16) en retrait, accessible de l'extérieur, pour la mise en contact électrique d'un composant accessoire (26) pour une caméra cinématographique (42), pour retenir le composant accessoire (26) pour une caméra cinématographique (42), à savoir un moteur d'actionnement pour une bague d'objectif ou pour une unité de filtre, un module radio pour une transmission de données sans fil, ou un écran pour afficher des données, par rapport à la caméra (42) dans une position variable le long d'un axe longitudinal (L) de la barre de retenue (12), le composant accessoire (26) étant fixé à la barre de retenue (12).

17. Composant accessoire (26) pour une caméra cinématographique (42), comprenant un dispositif de fixation (44) configuré pour fixer le composant accessoire (26) dans une position, variable par rapport à la caméra (42), le long d'un axe longitudinal (L) d'une barre de retenue (12), et un collecteur de courant électrique (34) configuré pour s'engager dans un renfoncement (14) de la barre de retenue (12) afin d'établir un contact électrique avec une zone de contact (16) située dans le renfoncement (14),
le composant accessoire (26) étant un moteur d'actionnement pour une bague d'objectif ou pour une unité de filtre, ou un module radio pour une transmission de données sans fil, ou un écran pour afficher des données.
